(19) **Europäisches Patentamt / European Patent Office / Office européen des brevets**

(11) **EP 4 344 056 B1**

(12) **EUROPEAN PATENT SPECIFICATION**

(45) Date of publication and mention
of the grant of the patent:
**26.11.2025  Bulletin 2025/48**

(21) Application number: **23746110.8**

(22) Date of filing: **17.01.2023**

(51) International Patent Classification (IPC):
**H02S 50/10** (2014.01)     **G01R 27/02** (2006.01)

(52) Cooperative Patent Classification (CPC):
**H02S 50/10; G01R 27/02; Y02E 10/50**

(86) International application number:
**PCT/CN2023/072533**

(87) International publication number:
**WO 2023/143228 (03.08.2023 Gazette 2023/31)**

(54) **EQUIVALENT IMPEDANCE MEASUREMENT METHOD AND APPARATUS FOR PHOTOVOLTAIC ASSEMBLY**

VERFAHREN UND VORRICHTUNG ZUR MESSUNG DER ÄQUIVALENTEN IMPEDANZ FÜR EINE FOTOVOLTAISCHE ANORDNUNG

APPAREIL ET PROCÉDÉ DE MESURE D'IMPÉDANCE ÉQUIVALENTE POUR ENSEMBLE PHOTOVOLTAÏQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **29.01.2022  CN 202210112400**

(43) Date of publication of application:
**27.03.2024  Bulletin 2024/13**

(73) Proprietor: **Huawei Digital Power Technologies Co., Ltd.**
**Shenzhen, Guangdong 518043 (CN)**

(72) Inventors:
• **LIU, Fangcheng**
**Shenzhen, Guangdong 518043 (CN)**
• **WANG, Kun**
**Shenzhen, Guangdong 518043 (CN)**
• **XIN, Kai**
**Shenzhen, Guangdong 518043 (CN)**

(74) Representative: **Isarpatent**
**Patent- und Rechtsanwälte**
**Barth Hassa Peckmann & Partner mbB**
**Friedrichstraße 31**
**80801 München (DE)**

(56) References cited:
EP-A1- 2 388 603     EP-A1- 2 388 603
CN-A- 103 048 544    CN-A- 106 026 170
CN-A- 107 315 112    CN-A- 108 535 545
CN-A- 109 444 541    CN-A- 109 521 276
CN-A- 109 521 276    CN-A- 114 553 137
CN-B- 106 026 170    US-A1- 2014 111 220

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

# Description

## TECHNICAL FIELD

This application relates to the field of power supply technologies, and in particular, to a method and an apparatus for measuring equivalent impedance of a photovoltaic module.

## BACKGROUND

In recent years, the installed capacity of photovoltaic has been increasing and gradually photovoltaic becomes the mainstream power generation technology. Ensuring long-term reliable operation of a photovoltaic system is a key concern of the industry. Therefore, it is quite important to detect a state of health of a photovoltaic module.

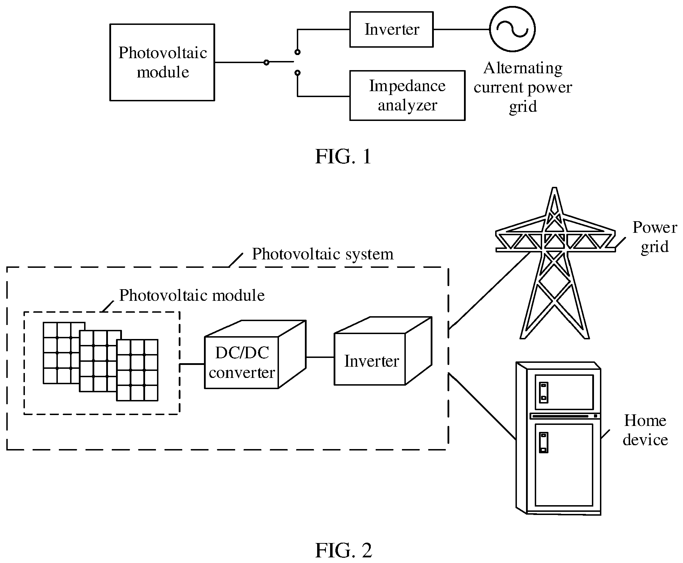

Currently in academic research, equivalent impedance of the photovoltaic module is measured to analyze the state of health of the photovoltaic module. An existing photovoltaic module impedance measurement method is mainly an offline photovoltaic module impedance measurement method, and the method is implemented by using an impedance analyzer in a typical photovoltaic module impedance detection system shown in FIG. 1. As shown in FIG. 1, when the equivalent impedance of the photovoltaic module is measured, the photovoltaic module connected to an inverter is disconnected and then connected to the impedance analyzer. In this case, the photovoltaic system stops generating electricity for a power grid, and the impedance analyzer generates an alternating current voltage of a specific frequency for the photovoltaic module, and measures an alternating current of the specific frequency, to calculate equivalent impedance of the photovoltaic module at the specific frequency.

Document US2014111220 discloses a method for diagnosing a fault within a solar cell system comprising measuring an impedance spectrum of the solar cell system and comparing it with a reference spectrum. According to the method, a DC signal is applied to the solar cell system and additionally an AC voltage with varying frequency, to achieve an impedance spectrum. The unit under investigation is isolated, and the DC bias is for determining the operating point only for the AC analysis.

However, in the foregoing offline photovoltaic module impedance measurement method, the photovoltaic module is disconnected from the inverter during equivalent impedance measurement, affecting a total energy yield of the photovoltaic system and causing poor applicability.

## SUMMARY

This application provides a method for measuring equivalent impedance of a photovoltaic module, a photovoltaic power generation device, an apparatus for measuring equivalent impedance of a photovoltaic module, and a photovoltaic system, without affecting an energy yield of the photovoltaic system during measurement of the equivalent impedance of the photovoltaic module, to implement high applicability.

According to a first aspect, this application provides a method for measuring equivalent impedance of a photovoltaic module. The photovoltaic module is connected to an input end of a photovoltaic power generation device. An output end of the photovoltaic power generation device is connected to a power grid. The method includes: generating a first drive signal based on a first reference voltage and an alternating current measurement signal of a first frequency, and controlling an output voltage of the photovoltaic module based on the first drive signal, where the first reference voltage is a reference input voltage of the photovoltaic power generation device in a state of supplying power to the power grid; and obtaining an output voltage and an output current that are of the photovoltaic module at the first frequency and that are controlled by the first drive signal, and determining the equivalent impedance of the photovoltaic module based on the output voltage and the output current of the photovoltaic module at the first frequency. In this way, the output voltage and the output current of the photovoltaic module and the alternating current measurement signal may be superposed to measure the equivalent impedance of the photovoltaic module based on appropriate power supply to the power grid, without affecting an energy yield of the photovoltaic system of the photovoltaic power generation device, to implement high applicability.

With reference to the first aspect, in a first possible implementation, if the first frequency is less than a frequency threshold, the first reference voltage and the alternating current measurement signal are superposed to obtain a second reference voltage; and a first modulation wave is generated based on the second reference voltage and a current output voltage of the photovoltaic module, and the first drive signal is generated based on the first modulation wave. It may be understood that if a frequency corresponding to the alternating current measurement signal is less than the frequency threshold, because a closed-loop injection manner of the alternating current measurement signal is used to generate the first drive signal, control precision can be effectively improved.

With reference to the first aspect, in a second possible implementation, if the first frequency is greater than or equal to a frequency threshold, a second modulation wave is generated based on the first reference voltage and a current output voltage of the photovoltaic module; and the second modulation wave and the alternating current measurement signal are superposed to obtain a third modulation wave, and the first drive signal is generated based on the third modulation wave. It may be understood that because a control unit integrated into a controller has a low-pass filter, the manner of generating the first drive signal in this implementation can effectively avoid that a high-frequency alternating current measurement signal (namely, an alternating current measurement signal whose frequency is greater than or equal to the frequency threshold) is filtered out by the low-pass filter in the control unit. This ensures that the first drive signal retains the complete high-frequency alternating current measurement signal.

With reference to the first aspect, in a third possible implementation, the photovoltaic power generation device is a DC/DC converter. The DC/DC converter includes a Boost circuit. The Boost circuit includes a first inductor and a first switching transistor. A positive input end of the Boost circuit is connected to a negative output end of the Boost circuit through the first inductor and the first switching transistor. Conduction duration of the first switching transistor is controlled based on the first drive signal, to control the output voltage of the photovoltaic module.

With reference to the first aspect, in a fourth possible implementation, the photovoltaic power generation device is an inverter. The inverter includes an inverter circuit. The inverter circuit includes a first phase bridge arm, a second phase bridge arm, and a third phase bridge arm. The first phase bridge arm, the second phase bridge arm, and the third phase bridge arm are all connected in parallel to an input end of the inverter circuit. The first drive signal includes a first drive subsignal, a second drive subsignal, and a third drive subsignal. Conduction duration of a switching transistor of the first phase bridge arm, conduction duration of a switching transistor of the second phase bridge arm, and conduction duration of a switching transistor of the third phase bridge arm are respectively controlled based on the first drive subsignal, the second drive subsignal, and the third drive subsignal, to control the output voltage of the photovoltaic module.

With reference to the first aspect, in a fifth possible implementation, an output voltage and an output current that are of the photovoltaic module and that are controlled by the first drive signal are collected, and frequency domain filtering is performed on the sampled output voltage and the sampled output current of the photovoltaic module based on the first frequency, to obtain the output voltage and the output current of the photovoltaic module at the first frequency.

With reference to the first aspect, in a sixth possible implementation, the first drive signal is generated based on the first reference voltage and alternating current measurement signals of at least two different frequencies, where the at least two different frequencies include the first frequency and a second frequency. The output voltage and the output current that are of the photovoltaic module at the first frequency and that are controlled by the first drive signal, and an output voltage and an output current of the photovoltaic module at the second frequency are obtained, and the equivalent impedance of the photovoltaic module is determined based on the output voltage and the output current of the photovoltaic module at the first frequency and the output voltage and the output current of the photovoltaic module at the second frequency. It may be understood that the alternating current measurement signals of the at least two different frequencies may be concentratedly injected at a time, to determine the equivalent impedance of the photovoltaic module based on the output voltage and the output current of the photovoltaic module at each of the at least two different frequencies. Compared with a manner of injecting alternating current measurement signals of different frequencies in batches, the manner of concentratedly injecting the alternating current measurement signals of the at least two different frequencies at a time in this implementation can effectively reduce workload of the photovoltaic power generation device, and improve working efficiency of the photovoltaic power generation device. In addition, in this implementation, compared with the manner of determining the equivalent impedance of the photovoltaic module based on the output voltage and the output current of the photovoltaic module at the first frequency, the manner of determining the equivalent impedance of the photovoltaic module based on the output voltage and the output current of the photovoltaic module at each of the at least two different frequencies can effectively improve measurement accuracy of the equivalent impedance of the photovoltaic module, and implement high applicability.

With reference to the first aspect, in a seventh possible implementation, each of the at least two different frequencies is less than the frequency threshold, or each of the at least two different frequencies is greater than or equal to the frequency threshold.

With reference to the first aspect, in an eighth possible implementation, the first drive signal is generated based on the first reference voltage and the alternating current measurement signal of the first frequency, the output voltage of the photovoltaic module is controlled based on the first drive signal, and the output voltage and the output current that are of the photovoltaic module at the first frequency and that are controlled by the first drive signal are obtained. Then, a second drive signal is generated based on the first reference voltage and an alternating current measurement signal of a second frequency, the output voltage of the photovoltaic module is controlled based on the second drive signal, and an output voltage and an output current that are of the photovoltaic module at the second frequency and that are controlled by the second drive signal are obtained. The equivalent impedance of the photovoltaic module is determined based on the output voltage and the output current of the photovoltaic module at the first frequency and the output voltage and the output current of the photovoltaic module at the second frequency. It may be understood that compared with a manner of injecting alternating current measurement signals of different frequencies in batches, the manner of concentratedly injecting the alternating current measurement signals of the at least two different frequencies at a time to measure the equivalent impedance of the photovoltaic module does not need to limit a value of each of the at least two different frequencies in this implementation. In addition, in this implementation, compared with the manner of determining the equivalent impedance of the photovoltaic module based on the output voltage and the output current of the photovoltaic module at the first frequency, the manner of determining the equivalent impedance of the photovoltaic module based on the output voltage and the output current of the photovoltaic module at each of the at least two different frequencies can effectively improve measurement accuracy of the equivalent impedance of the photovoltaic module, and implement high applicability.

With reference to the first aspect, in a ninth possible implementation, an equivalent impedance component of the photovoltaic module at the first frequency is determined based on the output voltage and the output current of the photovoltaic module at the first frequency, an equivalent impedance component of the photovoltaic module at the second frequency is determined based on the output voltage and the output current of the photovoltaic module at the second frequency, and the equivalent impedance of the photovoltaic module is further determined based on the equivalent impedance component of the photovoltaic module at the first frequency and the equivalent impedance component of the photovoltaic module at the second frequency.

With reference to the first aspect, in a tenth possible implementation, a current working status of the photovoltaic power generation device is determined, and the first reference voltage is determined based on the current working status of the photovoltaic power generation device, where the first reference voltage is a reference input voltage of the photovoltaic power generation device in a power-limited working state, or a reference input voltage of the photovoltaic power generation device in a power-unlimited working state. It may be understood that the first reference voltage changes with the current working state (namely, the power-limited working state or the power-unlimited working state) of the photovoltaic power generation device. Therefore, the photovoltaic power generation device in different working states can effectively supply power to the power grid, and flexibility is high.

According to a second aspect, this application provides a photovoltaic power generation device. An input end of the photovoltaic power generation device is connected to a photovoltaic module. An output end of the photovoltaic power generation device is connected to a power grid. The photovoltaic power generation device includes a controller and a power supply circuit. An input end of the power supply circuit is connected to the input end of the photovoltaic power generation device. An output end of the power supply circuit is connected to the output end of the photovoltaic power generation device. The power supply circuit is configured to convert an output voltage of the photovoltaic module into an output voltage of the photovoltaic power generation device in a state of supplying power to the power grid. The controller generates a first drive signal based on a first reference voltage and an alternating current measurement signal of a first frequency, and controls an output voltage of the photovoltaic module based on the first drive signal, where the first reference voltage is a reference input voltage of the photovoltaic power generation device in the state of supplying power to the power grid. Then, the controller obtains an output voltage and an output current that are of the photovoltaic module at the first frequency and that are controlled by the first drive signal, and determines equivalent impedance of the photovoltaic module based on the output voltage and the output current of the photovoltaic module at the first frequency.

With reference to the second aspect, in a first possible implementation, if the first frequency is less than a frequency threshold, the controller superposes the first reference voltage and the alternating current measurement signal to obtain a second reference voltage, generates a first modulation wave based on the second reference voltage and a current output voltage of the photovoltaic module, and then generates the first drive signal based on the first modulation wave.

With reference to the second aspect, in a second possible implementation, if the first frequency is greater than or equal to a frequency threshold, the controller generates a second modulation wave based on the first reference voltage and a current output voltage of the photovoltaic module, superposes the second modulation wave and the alternating current measurement signal to obtain a third modulation wave, and generates the first drive signal based on the third modulation wave.

With reference to the second aspect, in a third possible implementation, the photovoltaic power generation device is a DC/DC converter. The DC/DC converter includes a Boost circuit. The Boost circuit includes a first inductor and a first switching transistor. A positive input end of the Boost circuit is connected to a negative output end of the Boost circuit through the first inductor and the first switching transistor. The controller controls conduction duration of the first switching transistor based on the first drive signal, to control the output voltage of the photovoltaic module.

With reference to the second aspect, in a fourth possible implementation, the photovoltaic power generation device is an inverter. The inverter includes an inverter circuit. The inverter circuit includes a first phase bridge arm, a second phase bridge arm, and a third phase bridge arm. The first phase bridge arm, the second phase bridge arm, and the third phase bridge arm are all connected in parallel to an input end of the inverter circuit. The first drive signal includes a first drive subsignal, a second drive subsignal, and a third drive subsignal. The controller respectively controls conduction duration of a switching transistor of the first phase bridge arm, conduction duration of a switching transistor of the second phase bridge arm, and conduction duration of a switching transistor of the third phase bridge arm based on the first drive subsignal, the second drive subsignal, and the third drive subsignal, to control the output voltage of the photovoltaic module.

With reference to the second aspect, in a fifth possible implementation, the controller collects an output voltage and an output current that are of the photovoltaic module and that are controlled by the first drive signal, and performs frequency domain filtering on the sampled output voltage and the sampled output current of the photovoltaic module based on the first frequency, to obtain the output voltage and the output current of the photovoltaic module at the first frequency.

With reference to the second aspect, in a sixth possible implementation, the controller generates the first drive signal based on the first reference voltage and alternating current measurement signals of at least two different frequencies, where the at least two different frequencies include the first frequency and a second frequency. The controller obtains the output voltage and the output current that are of the photovoltaic module at the first frequency and that are controlled by the first drive signal, and an output voltage and an output current of the photovoltaic module at the second frequency, and determines the equivalent impedance of the photovoltaic module based on the output voltage and the output current of the photovoltaic module at the first frequency and the output voltage and the output current of the photovoltaic module at the second frequency.

With reference to the second aspect, in a seventh possible implementation, each of the at least two different frequencies is less than the frequency threshold, or each of the at least two different frequencies is greater than or equal to the frequency threshold.

With reference to the second aspect, in an eighth possible implementation, the controller generates the first drive signal based on the first reference voltage and the alternating current measurement signal of the first frequency, controls the output voltage of the photovoltaic module based on the first drive signal, and obtains the output voltage and the output current that are of the photovoltaic module at the first frequency and that are controlled by the first drive signal; generates a second drive signal based on the first reference voltage and an alternating current measurement signal of a second frequency, controls the output voltage of the photovoltaic module based on the second drive signal, and controls an output voltage and an output current that are of the photovoltaic module at the second frequency and that are controlled by the second drive signal; and determines the equivalent impedance of the photovoltaic module based on the output voltage and the output current of the photovoltaic module at the first frequency and the output voltage and the output current of the photovoltaic module at the second frequency.

With reference to the second aspect, in a ninth possible implementation, the controller determines an equivalent impedance component of the photovoltaic module at the first frequency based on the output voltage and the output current of the photovoltaic module at the first frequency, determines an equivalent impedance component of the photovoltaic module at the second frequency based on the output voltage and the output current of the photovoltaic module at the second frequency, and further determines the equivalent impedance of the photovoltaic module based on the equivalent impedance component of the photovoltaic module at the first frequency and the equivalent impedance component of the photovoltaic module at the second frequency.

With reference to the second aspect, in a tenth possible implementation, the controller determines a current working status of the photovoltaic power generation device, and determines the first reference voltage based on the current working status of the photovoltaic power generation device, where the first reference voltage is a reference input voltage of the photovoltaic power generation device in a power-limited working state, or a reference input voltage of the photovoltaic power generation device in a power-unlimited working state.

This application further discloses an apparatus for measuring equivalent impedance of a photovoltaic module. The apparatus is located in a photovoltaic power generation device. The apparatus may be the controller according to any one of the second aspect or the possible implementations of the second aspect. The apparatus includes:

a control module, configured to generate a first drive signal based on a first reference voltage and an alternating current measurement signal of a first frequency, and control an output voltage of the photovoltaic module based on the first drive signal, where the first reference voltage is a reference input voltage of the photovoltaic power generation device in a state of supplying power to a power grid;

an obtaining module, configured to obtain an output voltage and an output current that are of the photovoltaic module at the first frequency and that are controlled by the first drive signal; and

a first determining module, configured to determine the equivalent impedance of the photovoltaic module based on the output voltage and the output current of the photovoltaic module at the first frequency.

With reference to said apparatus, in a first possible implementation, the control module includes:

a first superposition unit, configured to superpose the first reference voltage and the alternating current measurement signal to obtain a second reference voltage;

a control unit, configured to generate a first modulation wave based on the second reference voltage and a current output voltage of the photovoltaic module; and

a modulation unit, configured to generate the first drive signal based on the first modulation wave.

With reference to said apparatus, in a second possible implementation, the control module includes:

a control unit, configured to generate a second modulation wave based on the first reference voltage and a current output voltage of the photovoltaic module; a second superposition unit, configured to superpose the second modulation wave and the alternating current measurement signal to obtain a third modulation wave; and
a modulation unit, configured to generate the first drive signal based on the third modulation wave.

With reference to said apparatus, in a third possible implementation, the photovoltaic power generation device is a DC/DC converter. The DC/DC converter includes a Boost circuit. The Boost circuit includes a first inductor and a first switching transistor. A positive input end of the Boost circuit is connected to a negative output end of the Boost circuit through the first inductor and the first switching transistor. The control module is configured to control conduction duration of the first switching transistor based on the first drive signal.

With reference to the third aspect, in a fourth possible implementation, the photovoltaic power generation device is an inverter. The inverter includes an inverter circuit. The inverter circuit includes a first phase bridge arm, a second phase bridge arm, and a third phase bridge arm. The first phase bridge arm, the second phase bridge arm, and the third phase bridge arm are all connected in parallel to an input end of the inverter circuit. The first drive signal includes a first drive subsignal, a second drive subsignal, and a third drive subsignal. The control module is configured to respectively control conduction duration of a switching transistor of the first phase bridge arm, conduction duration of the second phase bridge arm, and conduction duration of a switching transistor of the third phase bridge arm based on the first drive subsignal, the second drive subsignal, and the third drive subsignal.

With reference to said apparatus, in a fifth possible implementation, the obtaining module includes:

a sampling unit, configured to collect an output voltage and an output current that are of the photovoltaic module and that are controlled by the first drive signal; and
a filtering unit, configured to perform frequency domain filtering on the sampled output voltage and the sampled output current of the photovoltaic module based on the first frequency, to obtain the output voltage and the output current of the photovoltaic module at the first frequency.

With reference to said apparatus, in a sixth possible implementation, the control module is configured to generate the first drive signal based on the first reference voltage and alternating current measurement signals of at least two different frequencies, where the at least two different frequencies include the first frequency and a second frequency.

The obtaining module is configured to obtain the output voltage and the output current that are of the photovoltaic module at the first frequency and that are controlled by the first drive signal, and an output voltage and an output current of the photovoltaic module at the second frequency.

The first determining module is configured to determine the equivalent impedance of the photovoltaic module based on the output voltage and the output current of the photovoltaic module at the first frequency and the output voltage and the output current of the photovoltaic module at the second frequency.

With reference to said apparatus, in a seventh possible implementation, each of the at least two different frequencies is less than a frequency threshold, or each of the at least two different frequencies is greater than or equal to a frequency threshold.

With reference to said apparatus, in an eighth possible implementation, the control module is further configured to generate a second drive signal based on the first reference voltage and an alternating current measurement signal of the second frequency, and control the output voltage of the photovoltaic module based on the second drive signal.

The obtaining module is further configured to obtain an output voltage and an output current that are of the photovoltaic module at the second frequency and that are controlled by the second drive signal.

The first determining module is configured to determine the equivalent impedance of the photovoltaic module based on the output voltage and the output current of the photovoltaic module at the first frequency and the output voltage and the output current of the photovoltaic module at the second frequency.

With reference to said apparatus, in a ninth possible implementation, the first determining module is configured to: determine an equivalent impedance component of the photovoltaic module at the first frequency based on the output voltage and the output current of the photovoltaic module at the first frequency, and determine an equivalent impedance component of the photovoltaic module at the second frequency based on the output voltage and the output current of the photovoltaic module at the second frequency; and
determine the equivalent impedance of the photovoltaic module based on the equivalent impedance component of the photovoltaic module at the first frequency and the equivalent impedance component of the photovoltaic module at the second frequency.

With reference to said apparatus, in a tenth possible implementation, the apparatus further includes a second determining module.

The second determining module is configured to: determine a current working status of the photovoltaic power generation device, and determine the first reference voltage based on the current working status of the photovoltaic power generation device, where the first reference voltage is a reference input voltage of the photovoltaic power generation device in a power-limited working state, or a reference input voltage of the photovoltaic power generation device in a power-unlimited working state.

This application also discloses a photovoltaic system. The photovoltaic system includes a photovoltaic module and the photovoltaic power generation device according to any one of the second aspect to the possible implementations of the second aspect, or the apparatus for measuring equivalent impedance of a photovoltaic module according to the present disclosure.

It should be understood that, for implementations and beneficial effects of the foregoing aspects of this application, reference may be made to each other.

**BRIEF DESCRIPTION OF DRAWINGS**

FIG. 1 is a schematic diagram of a structure of a typical photovoltaic module impedance detection system in a conventional technology;

FIG. 2 is a schematic diagram of an application scenario of a photovoltaic system according to this application;

FIG. 3 is a schematic diagram of a structure of a photovoltaic system according to this application;

FIG. 4 is a schematic diagram of a structure of an apparatus for measuring equivalent impedance of a photovoltaic module according to this application;

FIG. 5 is another schematic diagram of a structure of an apparatus for measuring equivalent impedance of a photovoltaic module according to this application;

FIG. 6 is another schematic diagram of a structure of a photovoltaic system according to this application;

FIG. 7 is another schematic diagram of a structure of a photovoltaic system according to this application;

FIG. 8 is a schematic diagram of a photovoltaic module model according to this application;

FIG. 9 is a schematic diagram of a waveform of an output voltage and an output current of a photovoltaic module according to this application;

FIG. 10 is another schematic diagram of a structure of a photovoltaic system according to this application;

FIG. 11 is another schematic diagram of a waveform of an output voltage and an output current of a photovoltaic module according to this application;

FIG. 12 is another schematic diagram of a structure of a photovoltaic system according to this application;

FIG. 13 is another schematic diagram of a structure of a photovoltaic system according to this application;

FIG. 14 is another schematic diagram of a structure of a photovoltaic system according to this application;

FIG. 15 is still another schematic diagram of a structure of a photovoltaic system according to this application; and

FIG. 16 is a schematic flowchart of a method for measuring equivalent impedance of a photovoltaic module according to this application.

**DESCRIPTION OF EMBODIMENTS**

A photovoltaic system provided in this application is applicable to different application scenarios, for example, a photovoltaic power supply scenario and a solar and storage hybrid power supply scenario. In the photovoltaic power supply scenario, a power supply is a photovoltaic module. In the solar and storage hybrid power supply scenario, a power supply includes a photovoltaic module and an energy storage battery string. The following uses the photovoltaic power supply scenario as an example.

Refer to FIG. 2. FIG. 2 is a schematic diagram of an application scenario of a photovoltaic system according to this application. In the photovoltaic power supply scenario, the photovoltaic system may include a photovoltaic module, a DC/DC converter, and an inverter. A photovoltaic power generation device is applicable to the DC/DC converter in the photovoltaic system. The photovoltaic module is connected to an input end of the DC/DC converter. An output end of the DC/DC converter is connected to an input end of the inverter. An output end of the inverter is connected to an alternating current power grid or a home device. Optionally, there may be a plurality of photovoltaic modules connected to the input end of the DC/DC converter herein, and the plurality of photovoltaic modules may be connected in series and/or in parallel and then connected to the DC/DC converter. After the photovoltaic system starts to run, the DC/DC converter may convert a direct current generated by the photovoltaic module connected to the input end of the DC/DC converter into a direct current whose voltage is a preset value, and output the direct current to the inverter. The inverter inverts the direct current output by the DC/DC converter into an alternating current, to supply power to various types of electric devices such as the alternating current power grid or an alternating current load (such as the home device). The DC/DC converter in the photovoltaic system can measure equivalent impedance of the photovoltaic module based on appropriate power supply to the alternating current power grid or the alternating current load, without affecting an energy yield of the photovoltaic system during measurement of the equivalent impedance of the photovoltaic module, to implement high applicability.

The foregoing is merely an example of an application scenario of the photovoltaic system provided in this application, and is not exhaustive. The application scenario is not limited in this application.

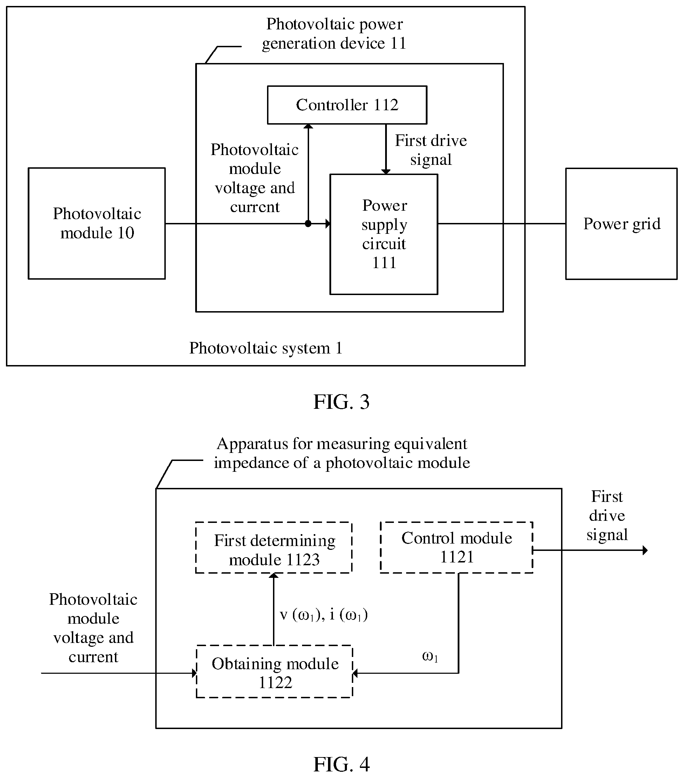

The following describes, with reference to FIG. 3 to FIG. 14, working principles of a photovoltaic system and a photovoltaic power generation device provided in this application by using examples.

Refer to FIG. 3. FIG. 3 is a schematic diagram of a structure of a photovoltaic system according to this application. As shown in FIG. 3, a photovoltaic system 1 includes a photovoltaic module 10 and a photovoltaic power generation device 11. An input end of the photovoltaic power generation device 11 is connected to the photovoltaic module 10, and an output end is connected to a power grid. The photovoltaic power generation device 11 includes a power supply circuit 111 and a controller 112. An input end of the power supply circuit 111 is connected to the input end of the photovoltaic power generation device 11. An output end of the power supply circuit 111 is connected to the output end of the photovoltaic power generation device 11. The power supply circuit 111 is configured to convert an output voltage of the photovoltaic module 10 into an output voltage of the photovoltaic power generation device 11 in a state of supplying power to the power grid.

In an optional implementation, the controller 112 is configured to generate a first drive signal based on a first reference voltage and an alternating current measurement signal of a first frequency, and control an output voltage of the photovoltaic module 10 based on the first drive signal, where the first reference voltage is a reference input voltage of the photovoltaic power generation device 11 in the state of supplying power to the power grid. Then, the controller 112 obtains an output voltage and an output current that are of the photovoltaic module 10 at the first frequency and that are controlled by the first drive signal, and determines equivalent impedance of the photovoltaic module 10 based on the output voltage and the output current of the photovoltaic module 10 at the first frequency.

The controller 112 provided in this application may be an apparatus for measuring equivalent impedance of a photovoltaic module. For ease of description, refer to FIG. 4. FIG. 4 is a schematic diagram of a structure of an apparatus for measuring equivalent impedance of a photovoltaic module according to this application. As shown in FIG. 4, the apparatus for measuring equivalent impedance includes a control module 1121, an obtaining module 1122, and a first determining module 1123.

The control module 1121 generates a first drive signal based on a first reference voltage $V_{ref1}$ and an alternating current measurement signal of a first frequency $\omega_1$, and outputs the first drive signal to the power supply circuit 111, so that the first drive signal controls the power supply circuit 111 to control an output voltage (namely, an input end voltage of the photovoltaic power generation device 11) of the photovoltaic module 10. Then, the obtaining module 1122 collects an output voltage and an output current that are of the photovoltaic module 10 in a first time interval $\Delta t_1$ and that are controlled by the first drive signal, performs frequency domain filtering on the output voltage and the output current of the photovoltaic module 10 in the first time interval $\Delta t_1$ based on the first frequency $\omega_1$ sent by the control module 1121, to obtain an output voltage $v(\omega_1)$ and an output current $i(\omega_1)$ of the photovoltaic module 10 at the first frequency $\omega_1$, and outputs the output voltage $v(\omega_1)$ and the output current $i(\omega_1)$ of the photovoltaic module 10 at the first frequency $\omega_1$ to the first determining module 1123. Further, the first determining module 1123 determines equivalent impedance $Z(\omega)$ of the photovoltaic module 10 based on the output voltage $v(\omega_1)$ and the output current $i(\omega_1)$ of the photovoltaic module 10 at the first frequency $\omega_1$.

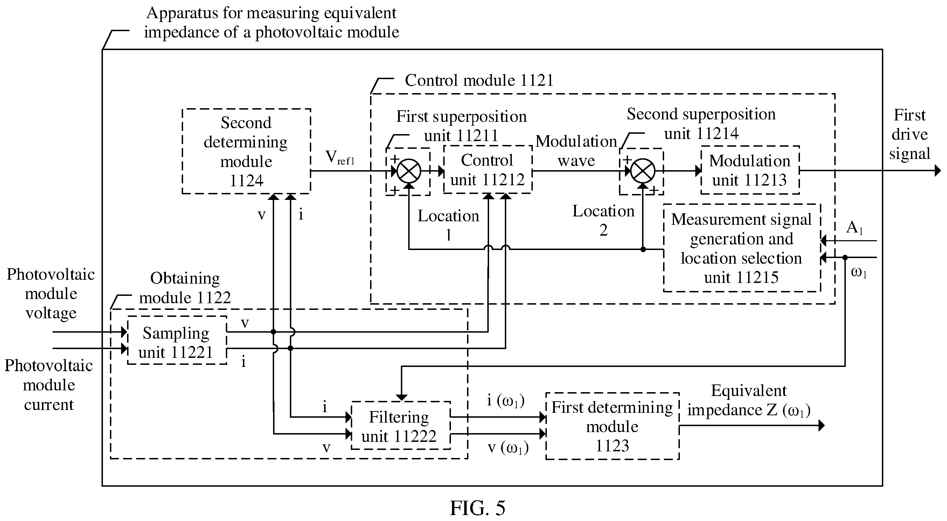

Further, refer to FIG. 5. FIG. 5 is another schematic diagram of a structure of an apparatus for measuring equivalent impedance of a photovoltaic module according to this application. As shown in FIG. 5, the control module 1121 includes a first superposition unit 11211, a control unit 11212, a modulation unit 11213, a second superposition unit 11214, and a measurement signal generation and location selection unit 11215. The obtaining module 1122 includes a sampling unit 11221 and a filtering unit 11222. The apparatus for measuring equivalent impedance further includes a second determining module 1124.

When the photovoltaic power generation device 11 starts to work, the sampling unit 11221 collects, in real time or at a preset frequency, a voltage and a current of a connection port between the photovoltaic module 10 and the power supply circuit 111, to obtain a current output voltage $v(t_1)$ and a current output current $i(t_1)$ of the photovoltaic module 10, and inputs the collected $v(t_1)$ and $i(t_1)$ to the second determining module 1124. The second determining module 1124 determines a current working status (namely, a power-unlimited working state or a power-limited working state) of the photovoltaic power generation device 11, determines the first reference voltage $V_{ref1}$ based on the current working status of the photovoltaic power generation device 11 and the current output voltage $v(t_1)$ and the current output current $i(t_1)$ of the photovoltaic module 10, and outputs the first reference voltage $V_{ref1}$ to the first superposition unit 11211. When the photovoltaic power generation device 11 is in the power-unlimited working state, the photovoltaic power generation device 11 performs maximum power point tracking (Maximum Power Point Tracking, MPPT) to maximize an output power. When the photovoltaic power generation device 11 is in the power-limited working state, the photovoltaic power generation device 11 actively limits the output power. The first reference voltage $V_{ref1}$ is a reference input voltage of the photovoltaic power generation device 11 in a state of supplying power to a power grid. In other words, in an entire measurement period of the equivalent impedance of the photovoltaic module 10, an average value of the output voltage of the photovoltaic module 10 may be kept equal to $V_{ref1}$, to maintain appropriate power generation operation of the photovoltaic system 1.

In addition, the measurement signal generation and location selection unit 11215 generates an alternating current measurement signal of a first frequency $\omega_1$ based on the first frequency $\omega_1$ and a first amplitude $A_1$, and selects a superposition unit (namely, the first superposition unit 11211 or the second superposition unit 11214) of the alternating current measurement signal of the first frequency $\omega_1$ based on the first frequency $\omega_1$, to output the alternating current measurement signal of the first frequency $\omega_1$ to the first superposition unit 11211 or the second superposition unit 11214.

If the first frequency $\omega_1$ is less than a frequency threshold $\omega_b$, the measurement signal generation and location selection unit 11215 determines the first superposition unit 11211 as the superposition unit of the alternating current measurement signal of the first frequency $\omega_1$, and outputs the alternating current measurement signal of the first frequency $\omega_1$ to the first superposition unit 11211. This manner is referred to as a closed-loop injection manner (of the alternating current measurement signal). If the first frequency $\omega_1$ is greater than or equal to a frequency threshold $\omega_b$, the measurement signal generation and location selection unit 11215 determines the second superposition unit 11214 as the superposition unit of the alternating current measurement signal of the first frequency $\omega_1$, and outputs the alternating current measurement signal of the first frequency $\omega_1$ to the second superposition unit 11214. This manner is referred to as an open-loop injection manner (of the alternating current measurement signal). A typical selection range of the frequency threshold $\omega_b$ is 1/10 to 1/5 of a switching frequency of the power supply circuit 111, and a frequency corresponding to the injected alternating current measurement signal is not greater than 1/2 of the switching frequency of the power supply circuit 111. For example, the switching frequency of the power supply circuit 111 is 40 kHz, and the frequency threshold $\omega_b$ is 1/10 of the switching frequency of the power supply circuit 111, that is, 4 kHz.

It should be noted that when closed-loop injection is performed, an amplitude of the alternating current measurement signal is a non-incremental function of the frequency. For example, when alternating current measurement signals of the first frequency $\omega_1$ and a second frequency $\omega_2$ are injected in the closed-loop injection manner, if $\omega_2$ is greater than $\omega_1$, $A_2$ is not greater than $A_1$, where $A_1$ is an amplitude of the alternating current measurement signal corresponding to $\omega_1$, and $A_2$ is an amplitude of the alternating current measurement signal corresponding to $\omega_2$. This can avoid that an increase of a detection frequency further increases a detection current and endangers safety of the photovoltaic system 1. This further improves safety of the photovoltaic system 1.

In an optional embodiment, if the measurement signal generation and location selection unit 11215 outputs the alternating current measurement signal of the first frequency $\omega_1$ to the first superposition unit 11211, the first superposition unit 11211 superposes the first reference voltage $V_{ref1}$ and the alternating current measurement signal of the first frequency $\omega_1$ to obtain a second reference voltage $V_{ref2}$, and outputs the second reference voltage $V_{ref2}$ to the control unit 11212. The control unit 11212 generates a first modulation wave based on the second reference voltage $V_{ref2}$ and the current output voltage $v(t_1)$ of the photovoltaic module 10, and outputs the first modulation wave to the second superposition unit 11214. The second superposition unit 11214 inputs the first modulation wave to the modulation unit 11213. The modulation unit 11213 generates the first drive signal based on the first modulation wave.

In another optional embodiment, if the measurement signal generation and location selection unit 11215 outputs the alternating current measurement signal of the first frequency $\omega_1$ to the second superposition unit 11214, the first superposition unit 11211 outputs the first reference voltage $V_{ref1}$ to the control unit 11212. The control unit 11212 generates a second modulation wave based on the first reference voltage $V_{ref1}$ and the current output voltage $v(t_1)$ of the photovoltaic module 10, and outputs the second modulation wave to the second superposition unit 11214. The second superposition unit 11214 superposes the second modulation wave and the alternating current measurement signal of the first frequency $\omega_1$ to obtain a third modulation wave, and outputs the third modulation wave to the modulation unit 11213. The modulation unit 11213 generates the first drive signal based on the third modulation wave.

Then, the modulation unit 11213 outputs the generated first drive signal to the power supply circuit 111, where the first drive signal is used to control an on-off status of a semiconductor switching device in the power supply circuit 111. Therefore, the alternating current measurement signal is generated at a port voltage of the photovoltaic module 10, and the average value of the output voltage of the photovoltaic module 10 maintains equal to the first reference voltage $V_{ref1}$.

The sampling unit 11221 collects an output voltage and an output current that are of the photovoltaic module 10 in a first time interval $\Delta t_1$ and that are controlled by the first drive signal, and outputs the output voltage and the output current of the photovoltaic module 10 in the first time interval $\Delta t_1$ to the filtering unit 11222. The filtering unit 11222 performs frequency domain filtering on the output voltage and the output current of the photovoltaic module 10 in the first time interval $\Delta t_1$ based on the first frequency $\omega_1$, to obtain an output voltage $v(\omega_1)$ and an output current $i(\omega_1)$ of the photovoltaic module 10 at the first frequency $\omega_1$, and outputs the output voltage $v(\omega_1)$ and the output current $i(\omega_1)$ of the photovoltaic module 10 at the first frequency $\omega_1$ to the first determining module 1123. The first determining module 1123 obtains equivalent impedance $Z(\omega)=v(\omega_1)/i(\omega_1)$ of the photovoltaic module 10 based on the output voltage $v(\omega_1)$ and the output current $i(\omega_1)$ of the photovoltaic module 10 at the first frequency $\omega_1$.

Further, to improve accuracy of measuring the equivalent impedance of the photovoltaic module 10, the apparatus for measuring equivalent impedance may further determine the equivalent impedance of the photovoltaic module 10 based on an output voltage and an output current of the photovoltaic module 10 at each of at least two frequencies, where the at least two frequencies include the first frequency $\omega_1$.

In an optional implementation, the control module 1121 generates the first drive signal based on the first reference voltage $V_{ref1}$ and alternating current measurement signals of at least two different frequencies, and controls the output voltage of the photovoltaic module 10 based on the first drive signal, where the at least two different frequencies include the first frequency $\omega_1$ and the second frequency $\omega_2$, and each of the at least two different frequencies is less than the frequency threshold $\omega_b$, or each of the at least two different frequencies is greater than or equal to the frequency threshold $\omega_b$. The obtaining module 1122 obtains an output voltage and an output current that are of the photovoltaic module 10 at each of the at least two different frequencies and that are controlled by the first drive signal. The first determining module 1123 determines the equivalent impedance of the photovoltaic module 10 based on the output voltage and the output current of the photovoltaic module 10 at each of the at least two different frequencies.

The second determining module 1124 determines the first reference voltage $V_{ref1}$ according to the manner of the foregoing embodiment, and outputs the first reference voltage $V_{ref1}$ to the first superposition unit 11211. In addition, the measurement signal generation and location selection unit 11215 generates the alternating current measurement signals of the at least two different frequencies based on the at least two different frequencies and at least one amplitude, and determines the superposition unit (namely, the first superposition unit 11211 or the second superposition unit 11214) of the alternating current measurement signal based on the at least two different frequencies corresponding to the alternating current measurement signal. One or more of the at least two different frequencies may correspond to one of the at least one amplitude.

In an optional embodiment, if each of the at least two different frequencies corresponding to the alternating current measurement signal is less than the frequency threshold $\omega_b$, the measurement signal generation and location selection unit 11215 determines the first superposition unit 11211 as the superposition unit of the alternating current measurement signals of the at least two different frequencies, and outputs the alternating current measurement signals of the at least two different frequencies to the first superposition unit 11211. The first superposition unit 11211 superposes the first reference voltage $V_{ref1}$ and the alternating current measurement signals of the at least two different frequencies to obtain the second reference voltage $V_{ref2}$, and outputs the second reference voltage $V_{ref2}$ to the control unit 11212. The control unit 11212 generates a first modulation wave based on the second reference voltage $V_{ref2}$ and the current output voltage $v(t_1)$ of the photovoltaic module 10, and outputs the first modulation wave to the second superposition unit 11214. The second superposition unit 11214 inputs the first modulation wave to the modulation unit 11213. The modulation unit 11213 generates the first drive signal based on the first modulation wave.

In another optional embodiment, if each of the at least two different frequencies corresponding to the alternating current measurement signal is greater than or equal to the frequency threshold $\omega_b$, the measurement signal generation and location selection unit 11215 determines the second superposition unit 11214 as the superposition unit of the alternating current measurement signals of the at least two different frequencies, and outputs the alternating current measurement signals of the at least two different frequencies to the second superposition unit 11214. The first superposition unit 11211 outputs the first reference voltage $V_{ref1}$ to the control unit 11212. The control unit 11212 generates a second modulation wave based on the first reference voltage $V_{ref1}$ and the current output voltage $v(t_1)$ of the photovoltaic module 10, and outputs the second modulation wave to the second superposition unit 11214. The second superposition unit 11214 superposes the second modulation wave and the alternating current measurement signals of the at least two different frequencies to obtain a third modulation wave, and outputs the third modulation wave to the modulation unit 11213. The modulation unit 11213 generates the first drive signal based on the third modulation wave.

Then, the modulation unit 11213 outputs the generated first drive signal to the power supply circuit 111, where the first drive signal is used to control an on-off status of a semiconductor switching device in the power supply circuit 111. Therefore, an alternating current signal with a corresponding voltage and current is generated at a port of the photovoltaic module 10, and the average value of the output voltage of the photovoltaic module 10 maintains equal to the first reference voltage $V_{ref1}$.

The sampling unit 11221 collects an output voltage and an output current that are of the photovoltaic module 10 in a first time interval $\Delta t_1$ and that are controlled by the first drive signal, and outputs the output voltage and the output current of the photovoltaic module 10 in the first time interval $\Delta t_1$ to the filtering unit 11222. The filtering unit 11222 performs frequency domain filtering on the output voltage and the output current of the photovoltaic module 10 in the first time interval $\Delta t_1$ based on the at least two different frequencies, to obtain an output voltage $v(\omega)$ and an output current $i(\omega)$ of the photovoltaic module 10 at the at least two different frequencies, and outputs the output voltage v $(\omega)$ and the output current i $(\omega)$ of the photovoltaic module 10 at the at least two different frequencies to the first determining module 1123.

The first determining module 1123 determines the equivalent impedance Z $(\omega)$ of the photovoltaic module 10 based on the output voltage v $(\omega)$ and the output current i $(\omega)$ of the photovoltaic module 10 at each of the at least two different frequencies.

In an optional embodiment, the at least two different frequencies further include the second frequency $\omega_2$, ..., and an $n^{th}$ frequency $\omega_n$, where n is an integer greater than 1. The first determining module 1123 obtains equivalent impedance components Z $(\omega_1)$=v $(\omega_1)$/i $(\omega_1)$, Z $(\omega_2)$=v $(\omega_2)$/i $(\omega_2)$, ..., and Z $(\omega_n)$=v $(\omega_n)$/i $(\omega_n)$ of the photovoltaic module 10 based on the output voltage v $(\omega_1)$ and the output current i $(\omega_1)$ of the photovoltaic module 10 at the first frequency $\omega_1$, an output voltage v $(\omega_2)$ and an output current i $(\omega_2)$ of the photovoltaic module 10 at the second frequency $\omega_2$, ..., and an output voltage v $(\omega_n)$ and an output current i $(\omega_n)$ of the photovoltaic module 10 at the $n^{th}$ frequency $\omega_n$. Then, the first determining module 1123 obtains the equivalent impedance Z $(\omega)$={Z $(\omega_1)$, Z $(\omega_2)$, ..., Z $(\omega_n)$} of the photovoltaic module 10 based on the equivalent impedance components Z $(\omega_1)$, Z $(\omega_2)$, ..., and Z $(wo_n)$ of the photovoltaic module 10.

In this implementation, the equivalent impedance of the photovoltaic module 10 may be measured in a manner of concentratedly injecting the alternating current measurement signals of the at least two different frequencies at a time. Compared with a manner of injecting alternating current measurement signals of different frequencies in batches, this manner can effectively reduce workload of the apparatus for measuring equivalent impedance, and improve working efficiency of the apparatus for measuring equivalent impedance.

In an optional implementation, the control module 1121 generates at least two drive signals based on the first reference voltage $V_{ref1}$ and the alternating current measurement signal of each frequency of the at least two alternating current measurement signals of the at least two different frequencies, where the at least two alternating current measurement signals of the at least two different frequencies include the alternating current measurement signal of the first frequency $\omega_1$. The control module 1121 controls the output voltage of the photovoltaic module 10 sequentially based on the at least two drive signals. The obtaining module 1122 obtains an output voltage and an output current that are of the photovoltaic module 10 at a frequency corresponding to each drive signal and that are controlled by each of the at least two drive signals. The first determining module 1123 determines the equivalent impedance of the photovoltaic module 10 based on the output voltage and the output current of the photovoltaic module 10 at the frequency corresponding to each drive signal.

The at least two measurement signals of the at least two different frequencies further include an alternating current measurement signal of a second frequency $\omega_2$, ..., and an alternating current measurement signal of an $n^{th}$ frequency $\omega_n$, where n is an integer greater than 1.

The control module 1121 generates the first drive signal based on the first reference voltage $V_{ref1}$ and the alternating current measurement signal of the first frequency $\omega_1$, and outputs the first drive signal to the power supply circuit 111, so that the first drive signal controls the power supply circuit 111 to control the output voltage of the photovoltaic module 10. Then, the obtaining module 1122 collects the output voltage and the output current that are of the photovoltaic module 10 in the first time interval $\Delta t_1$ and that are controlled by the first drive signal, performs frequency domain filtering on the output voltage and the output current of the photovoltaic module 10 in the first time interval $\Delta t_1$ based on the first frequency $\omega_1$, to obtain the output voltage v $(\omega_1)$ and the output current i $(\omega_1)$ of the photovoltaic module 10 at the first frequency $\omega_1$, and outputs the output voltage v $(\omega_1)$ and the output current i $(\omega_1)$ of the photovoltaic module 10 at the first frequency $\omega_1$ to the first determining module 1123.

Then, the control module 1121 generates a second drive signal based on the first reference voltage $V_{ref1}$ and the alternating current measurement signal of the second frequency $\omega_2$, and outputs the second drive signal to the power supply circuit 111, so that the second drive signal controls the power supply circuit 111 to control the output voltage of the photovoltaic module 10. Then, the obtaining module 1122 collects an output voltage and an output current that are of the photovoltaic module 10 in a second time interval $\Delta t_2$ and that are controlled by the second drive signal, and performs frequency domain filtering on the output voltage and the output current of the photovoltaic module 10 in the second time interval $\Delta t_2$ based on the second frequency $\omega_2$, to obtain the output voltage v $(\omega_2)$ and the output current i $(\omega_2)$ of the photovoltaic module 10 at the second frequency $\omega_2$, and outputs the output voltage v $(\omega_2)$ and the output current i $(\omega_2)$ of the photovoltaic module 10 at the second frequency $\omega_2$ to the first determining module 1123.

Similarly, the apparatus for measuring equivalent impedance of a photovoltaic module may sequentially obtain an output voltage v $(\omega_3)$ and an output current i $(\omega_3)$ of the photovoltaic module 10 at a third frequency $\omega_3$, ..., and the output voltage v $(\omega_n)$ and the output current i $(wo_n)$ of the photovoltaic module 10 at the $n^{th}$ frequency $\omega_n$ in the foregoing manner, and outputs the output voltage v $(\omega_3)$ and the output current i $(\omega_3)$ of the photovoltaic module 10 at the third frequency $\omega_3$, ..., and the output voltage v $(\omega_n)$ and the output current i $(wo_n)$ of the photovoltaic module 10 at the $n^{th}$ frequency $\omega_n$ to the first determining module 1123.

The first determining module 1123 obtains equivalent impedance components Z $(\omega_1)$=v $(\omega_1)$/i $(\omega_1)$,

$Z(\omega_2)=v(\omega_2)/i(\omega_2)$, ..., and $Z(\omega_n)=v(\omega_n)/i(wo_n)$ of the photovoltaic module 10 based on the output voltage $v(\omega_1)$ and the output current $i(\omega_1)$ of the photovoltaic module 10 at the first frequency $\omega_1$, the output voltage $v(\omega_2)$ and the output current $i(\omega_2)$ of the photovoltaic module 10 at the second frequency $\omega_2$, ..., and the output voltage $v(\omega_n)$ and the output current $i(\omega_n)$ of the photovoltaic module 10 at the $n^{th}$ frequency $\omega_n$. Then, the first determining module 1123 obtains the equivalent impedance $Z(\omega)=\{Z(\omega_1), Z(\omega_2), ..., Z(\omega_n)\}$ of the photovoltaic module 10 based on the equivalent impedance components $Z(\omega_1), Z(\omega_2), ...$, and $Z(wo_n)$ of the photovoltaic module 10.

It should be noted that when alternating current measurement signals of different frequencies are injected in batches, the open-loop injection manner and the closed-loop injection manner cannot be performed at the same time. In other words, in one injection process of the alternating current measurement signal, only one of the first superposition unit 11211 and the second superposition unit 11214 can be selected as the superposition unit of the alternating current measurement signal.

In this implementation, compared with a manner of injecting alternating current measurement signals of different frequencies in batches, the manner of concentratedly injecting the alternating current measurement signals of the at least two different frequencies at a time to measure the equivalent impedance of the photovoltaic module 10 does not need to limit a value of each of the at least two different frequencies in this implementation, to implement high applicability.

It may be understood that when power is supplied to the power grid by using the control module 1121 and the power supply circuit 111, the alternating current measurement signal of the photovoltaic module 10 may be injected, and then the equivalent impedance of the photovoltaic module 10 is measured by using the obtaining module 1122 and the first determining module 1123. Therefore, the equivalent impedance of the photovoltaic module 10 is measured, without affecting an energy yield of the photovoltaic system 1. In addition, because voltage and current levels of the impedance analyzer used in the offline photovoltaic module impedance measurement manner are limited, voltage and current levels in scenarios of a large photovoltaic system (namely, a large photovoltaic power station) and a small photovoltaic system (namely, a residential photovoltaic system) cannot be considered. In this application, the equivalent impedance of the photovoltaic module can be measured by using the photovoltaic power generation device connected to the photovoltaic module in the photovoltaic system. Therefore, compared with the offline photovoltaic module impedance measurement manner, this application can further consider voltage and current levels of all scenarios corresponding to the photovoltaic system without adding a hardware device, to implement high applicability.

For ease of description, the following describes an example in which the equivalent impedance of the photovoltaic module 10 is obtained in a manner of injecting alternating current measurement signals of three different frequencies (that is, $\omega_1$, $\omega_2$, and $\omega_3$) in batches.

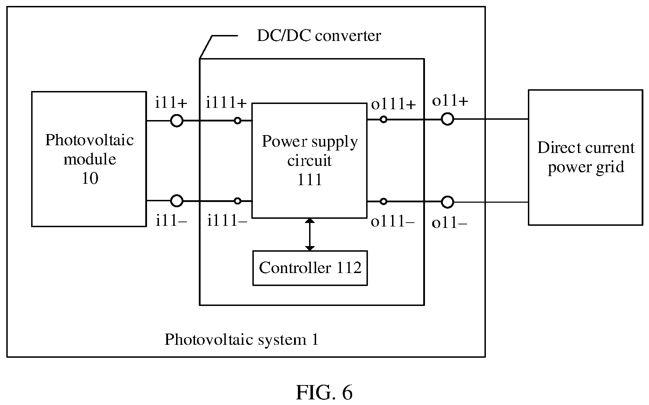

Refer to FIG. 6. FIG. 6 is another schematic diagram of a structure of a photovoltaic system according to this application. As shown in FIG. 6, the photovoltaic system 1 includes the photovoltaic module 10 and a DC/DC converter. The photovoltaic module 10 is connected to a direct current power grid through the DC/DC converter. In the photovoltaic system 1 shown in FIG. 6, the photovoltaic power generation device 11 provided in this application is the DC/DC converter. The DC/DC converter includes a power supply circuit 111 and a controller 112. Two input ends i111+ and i111- of the power supply circuit 111 are respectively connected to two input ends i11+ and i11- of the DC/DC converter. Two output ends o111+ and o111- of the power supply circuit 111 are respectively connected to two output ends o11+ and o11- of the DC/DC converter. The power supply circuit 111 may be a Boost circuit, a Buck circuit, or a Buck-Boost circuit.

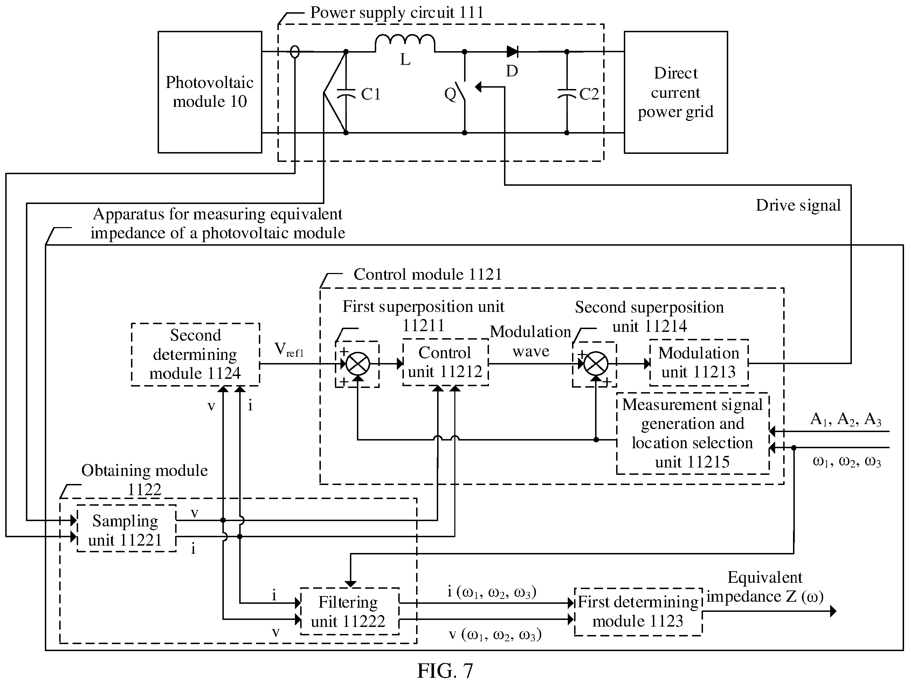

Further, for ease of description, the following describes an example in which the power supply circuit 111 is a Boost circuit. Refer to FIG. 7. FIG. 7 is another schematic diagram of a structure of a photovoltaic system according to this application. As shown in FIG. 7, the power supply circuit 111 is a Boost circuit including capacitors C1 and C2, an inductor L, a switching transistor Q, and a diode D. An apparatus for measuring equivalent impedance of a photovoltaic module in FIG. 7 corresponds to the controller 112 in FIG. 6.

In an optional implementation, after the photovoltaic system 1 starts to work, the DC/DC converter performs MPPT to maximize an output power. In this case, the DC/DC converter is in a power-unlimited working state. When determining that a current working status of the DC/DC converter is the power-unlimited working state, the second determining module 1124 implements an MPPT policy by using a disturbance observation method, changing a voltage (namely, an output voltage of the photovoltaic module 10) of a connection port between the photovoltaic module 10 and the power supply circuit 111 to change the output power of the photovoltaic module 10, and determining a first reference voltage $V_{ref1}$ as an output voltage of the photovoltaic module 10 corresponding to a maximum value of a plurality of changed output powers of the photovoltaic module 10. The second determining module 1124 determines the first reference voltage $V_{ref1}$, and then outputs the first reference voltage $V_{ref1}$ to the first superposition unit 11211.

In addition, the measurement signal generation and location selection unit 11215 generates an alternating current measurement signal of a first frequency $\omega_1$ based on the first frequency $\omega_1$ and a first amplitude $A_1$. Assuming that the first frequency $\omega_1$ is less than a frequency threshold $\omega_b$, the measurement signal generation and location selection unit 11215 determines the first superposition unit 11211 as a superposition unit of the alternating current measurement signal of the first frequency $\omega_1$, and outputs the alternating current measurement signal of the first frequency $\omega_1$ to the first superposition unit 11211.

The first superposition unit 11211 superposes the first reference voltage $V_{ref1}$ and the alternating current measurement signal of the first frequency $\omega_1$ to obtain a second reference voltage $V_{ref2}$, and outputs the second reference voltage $V_{ref2}$ to the control unit 11212. The control unit 11212 generates a first modulation wave based on the second reference voltage $V_{ref2}$ and a current output voltage $v(t_1)$ of the photovoltaic module 10, and outputs the first modulation wave to the second superposition unit 11214. The control unit 11212 herein may be a voltage controller, such as a proportional-integral (Proportional-Integral, PI) regulator. The second superposition unit 11214 inputs the first modulation wave to the modulation unit 11213. The modulation unit 11213 generates a first drive signal (for example, a square wave) based on the first modulation wave. The modulation unit 11213 herein may be a pulse width modulation (Pulse width modulation, PWM) unit.

Then, the modulation unit 11213 outputs the generated first drive signal to the switching transistor Q of the power supply circuit 111, where the first drive signal is used to control conduction duration of the switching transistor Q. Therefore, the alternating current measurement signal of the first frequency $\omega_1$ is generated at an output voltage of the photovoltaic module 10, and an average value of the output voltage of the photovoltaic module 10 maintains equal to the first reference voltage $V_{ref1}$.

The sampling unit 11221 collects an output voltage and an output current that are of the photovoltaic module 10 in a first time interval $\Delta t_1$ and that are controlled by the first drive signal, and outputs the output voltage and the output current of the photovoltaic module 10 in the first time interval $\Delta t_1$ to the filtering unit 11222. The filtering unit 11222 separately performs discrete Fourier transform (Discrete Fourier Transform, DFT) on the output voltage and the output current of the photovoltaic module 10 in the first time interval $\Delta t_1$ based on the first frequency $\omega_1$, to obtain an output voltage $v(\omega_1)$ and an output current $i(\omega_1)$ of the photovoltaic module 10 at the first frequency $\omega_1$, and outputs the output voltage $v(\omega_1)$ and the output current $i(\omega_1)$ of the photovoltaic module 10 at the first frequency $\omega_1$ to the first determining module 1123. The first determining module 1123 obtains an equivalent impedance component $Z(\omega_1)=v(\omega_1)/i(\omega_1)$ of the photovoltaic module 10 through calculation based on the output voltage $v(\omega_1)$ and the output current $i(\omega_1)$ of the photovoltaic module 10 at the first frequency $\omega_1$.

Then, the measurement signal generation and location selection unit 11215 generates an alternating current measurement signal of a second frequency $\omega_2$ based on the second frequency $\omega_2$ and a second amplitude $A_2$. Assuming that the second frequency $\omega_2$ is greater than the frequency threshold $\omega_b$, the measurement signal generation and location selection unit 11215 determines the second superposition unit 11214 as a superposition unit of the alternating current measurement signal of the second frequency $\omega_2$, and outputs the alternating current measurement signal of the second frequency $\omega_2$ to the second superposition unit 11214.

The first superposition unit 11211 outputs the first reference voltage $V_{ref1}$ to the control unit 11212. The control unit 11212 generates a fourth modulation wave based on the first reference voltage $V_{ref1}$ and the current output voltage $v(t_1)$ of the photovoltaic module 10, and outputs the fourth modulation wave to the second superposition unit 11214. The second superposition unit 11214 superposes the fourth modulation wave and the alternating current measurement signal of the second frequency $\omega_2$ to obtain a fifth modulation wave, and outputs the fifth modulation wave to the modulation unit 11213. The modulation unit 11213 generates the second drive signal based on the fifth modulation wave.

Then, the modulation unit 11213 outputs the generated second drive signal to the switching transistor Q of the power supply circuit 111, where the second drive signal is used to control conduction duration of the switching transistor Q. Therefore, the alternating current measurement signal of the second frequency $\omega_2$ is generated at an output voltage of the photovoltaic module 10, and an average value of the output voltage of the photovoltaic module 10 maintains equal to the first reference voltage $V_{ref1}$.

The sampling unit 11221 collects an output voltage and an output current that are of the photovoltaic module 10 in a second time interval $\Delta t_2$ and that are controlled by the second drive signal, and outputs the output voltage and the output current of the photovoltaic module 10 in the second time interval $\Delta t_2$ to the filtering unit 11222. The filtering unit 11222 separately performs DFT on the output voltage and the output current of the photovoltaic module 10 in the second time interval $\Delta t_2$ based on the second frequency $\omega_2$, to obtain an output voltage $v(\omega_2)$ and an output current $i(\omega_2)$ of the photovoltaic module 10 at the second frequency $\omega_2$, and outputs the output voltage $v(\omega_2)$ and the output current $i(\omega_2)$ of the photovoltaic module 10 at the second frequency $\omega_2$ to the first determining module 1123. The first determining module 1123 obtains an equivalent impedance component $Z(\omega_2)=v(\omega_2)/i(\omega_2)$ of the photovoltaic module 10 through calculation based on the output voltage $v(\omega_2)$ and the output current $i(\omega_2)$ of the photovoltaic module 10 at the second frequency $\omega_2$.

Then, the measurement signal generation and location selection unit 11215 generates an alternating current measurement signal of a third frequency $\omega_3$ based on the third frequency $\omega_3$ and a third amplitude $A_3$. The control module 1121 generates a third drive signal based on the first reference voltage $V_{ref1}$ and the alternating current measurement signal of the third

frequency $\omega_3$, and controls the output voltage of the photovoltaic module 10 based on the third drive signal. Herein, for a specific implementation in which the control module 1121 generates the third drive signal and controls the output voltage of the photovoltaic module 10 based on the third drive signal, refer to the foregoing descriptions in which the control module 1121 generates the first drive signal and controls the output voltage of the photovoltaic module 10 based on the first drive signal. Details are not described herein again.

The sampling unit 11221 collects an output voltage and an output current that are of the photovoltaic module 10 in a third time interval $\Delta t_3$ and that are controlled by the third drive signal, and outputs the output voltage and the output current of the photovoltaic module 10 in the third time interval $\Delta t_3$ to the filtering unit 11222. The filtering unit 11222 separately performs DFT on the output voltage and the output current of the photovoltaic module 10 in the third time interval $\Delta t_3$ based on the third frequency $\omega_3$, to obtain an output voltage v $(\omega_3)$ and an output current i $(\omega_3)$ of the photovoltaic module 10 at the third frequency $\omega_3$, and outputs the output voltage v $(\omega_3)$ and the output current i $(\omega_3)$ of the photovoltaic module 10 at the third frequency $\omega_3$ to the first determining module 1123. The first determining module 1123 obtains an equivalent impedance component Z $(\omega_3)$=$_V$ $(\omega_3)$/i $(\omega_3)$ of the photovoltaic module 10 through calculation based on the output voltage v $(\omega_3)$ and the output current i $(\omega_3)$ of the photovoltaic module 10 at the third frequency $\omega_3$.

The first determining module 1123 obtains equivalent impedance Z $(\omega)$={Z $(\omega_1)$, Z $(\omega_2)$, Z $(\omega_3)$} of the photovoltaic module 10 based on the equivalent impedance components Z $(\omega_1)$, Z $(\omega_2)$, and Z $(\omega_3)$.

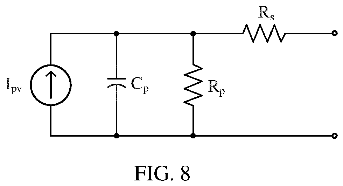

Further, to represent the equivalent impedance of the photovoltaic module 10 more visually, the first determining module 1123 may further obtain the equivalent impedance Z $(\omega)$ of the photovoltaic module 10 through calculation based on the equivalent impedance components Z $(\omega_1)$, Z $(\omega_2)$, and Z $(\omega_3)$, and a photovoltaic module model. For example, refer to FIG. 7. FIG. 7 is a schematic diagram of a photovoltaic module model according to this application. As shown in FIG. 8, the photovoltaic module 10 may be equivalent to a circuit including a current source $I_{pv}$, an inductor $C_p$, and resistors $R_p$ and $R_s$. Based on the equivalent impedance components Z $(\omega_1)$, Z $(\omega_2)$, and Z $(\omega_3)$ of the photovoltaic module 10 and the photovoltaic module model shown in FIG. 7, the following equation set may be established:

$$\begin{cases} Z(\omega_1) = R_s + R_p || (1/j\,\omega_1 C_p) \\ Z(\omega_2) = R_s + R_p || (1/j\,\omega_2 C_p) \\ Z(\omega_3) = R_s + R_p || (1/j\,\omega_3 C_p) \end{cases}$$

$C_p$, $R_p$, and $R_s$ in the photovoltaic module model may be solved according to the foregoing equation set, to obtain equivalent impedance $Z(\omega) = R_s + R_p || (1/j\,\omega C_p)$ of the photovoltaic module 10.

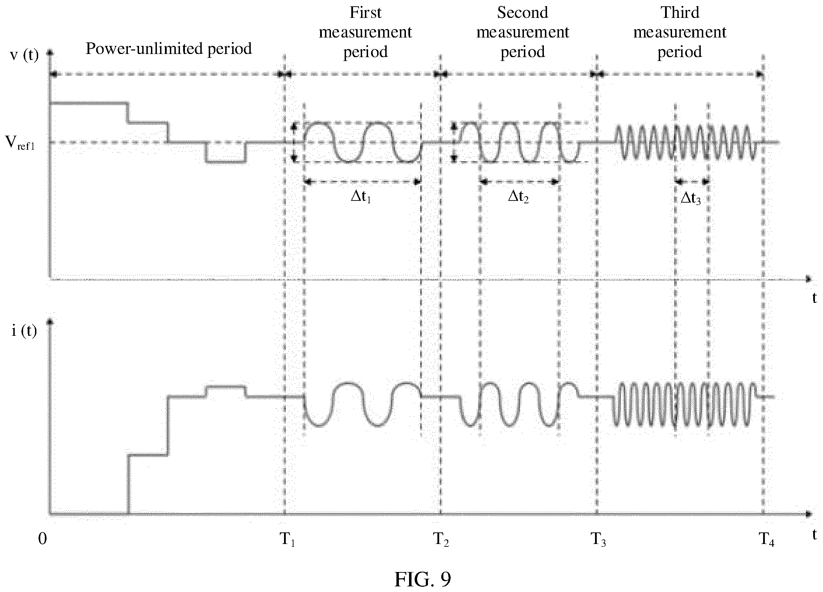

Further, refer to FIG. 9. FIG. 9 is a schematic diagram of a waveform of an output voltage and an output current of a photovoltaic module according to this application. As shown in FIG. 9, in a power-unlimited period 0 $< t < T_1$, after the DC/DC converter starts to run, the MPPT policy is implemented by using the disturbance observation method to determine the first reference voltage $V_{ref1}$, and it is ensured that the output voltage v (t) of the photovoltaic module 10 maintains at the first reference voltage $V_{ref1}$. After a moment $T_1$, the DC/DC converter measures equivalent impedance of the photovoltaic module 10 for the first time, controls conduction duration of the switching transistor Q based on the first drive signal, to inject an alternating current voltage of the first frequency $\omega_1$ into the photovoltaic module 10, records an output voltage v (t) and an output current i (t) of the photovoltaic module 10 in the first time interval $\Delta t_1$, and then obtains the equivalent impedance component Z $(\omega_1)$ of the photovoltaic module 10 through calculation based on the output voltage v (t) and output current i (t) of the photovoltaic module 10 in the first time interval $\Delta t_1$.

After a moment $T_2$, the DC/DC converter measures equivalent impedance of the photovoltaic module 10 for the second time, controls conduction duration of the switching transistor Q based on the second drive signal, to inject an alternating current voltage of the second frequency $\omega_2$ into the photovoltaic module 10, records an output voltage v (t) and an output current i (t) of the photovoltaic module 10 in the second time interval $\Delta t_2$, and then obtains the equivalent impedance component Z $(\omega_2)$ of the photovoltaic module 10 through calculation based on the output voltage v (t) and the output current i (t) of the photovoltaic module 10 in the second time interval $\Delta t_2$.

After a moment $T_3$, the DC/DC converter measures equivalent impedance of the photovoltaic module 10 for the third time, controls conduction duration of the switching transistor Q based on the third drive signal, to inject an alternating current voltage of the third frequency $\omega_3$ into the photovoltaic module 10, records an output voltage v (t) and an output current i (t) of the photovoltaic module 10 in the third time interval $\Delta t_3$, and then obtains the equivalent impedance component Z $(\omega_3)$ of the photovoltaic module 10 through calculation based on the output voltage v (t) and output current i (t) of the photovoltaic module 10 in the third time interval $\Delta t_3$.

After a moment $T_4$, the DC/DC converter obtains the equivalent impedance Z $(\omega)$ of the photovoltaic module 10 through calculation based on the equivalent impedance components Z $(\omega_1)$, Z $(\omega_2)$, and Z $(\omega_3)$ of the photovoltaic module 10.

In this embodiment, the DC/DC converter first controls the photovoltaic module 10 to work in the power-unlimited period, determines the first reference voltage $V_{ref1}$ and a reference current corresponding to the first reference voltage $V_{ref1}$, and respectively keeps the output voltage and the output current of the photovoltaic module 10 at the first reference voltage $V_{ref1}$ and the reference current corresponding to the first reference voltage $V_{ref1}$. Then, based on this, the output voltage v (t) and the output current i (t) of the photovoltaic module 10 and the alternating current measurement signal are superposed to measure the equivalent impedance of the photovoltaic module 10. In addition, it may be learned from FIG. 9 that when the equivalent impedance of the photovoltaic module 10 is measured, the output voltage v (t) and the output current i (t) of the photovoltaic module 10 fluctuate only slightly, and average values of the output voltage and the output current of the photovoltaic module 10 still maintain close to the first reference voltage $V_{ref1}$ and the reference current that are determined in the power-unlimited period. Therefore, the photovoltaic module equivalent impedance measurement manner provided in this application causes only a small power fluctuation in the measurement process, without affecting an energy yield of the photovoltaic system 1 like the offline photovoltaic module impedance measurement manner, to implement high applicability.

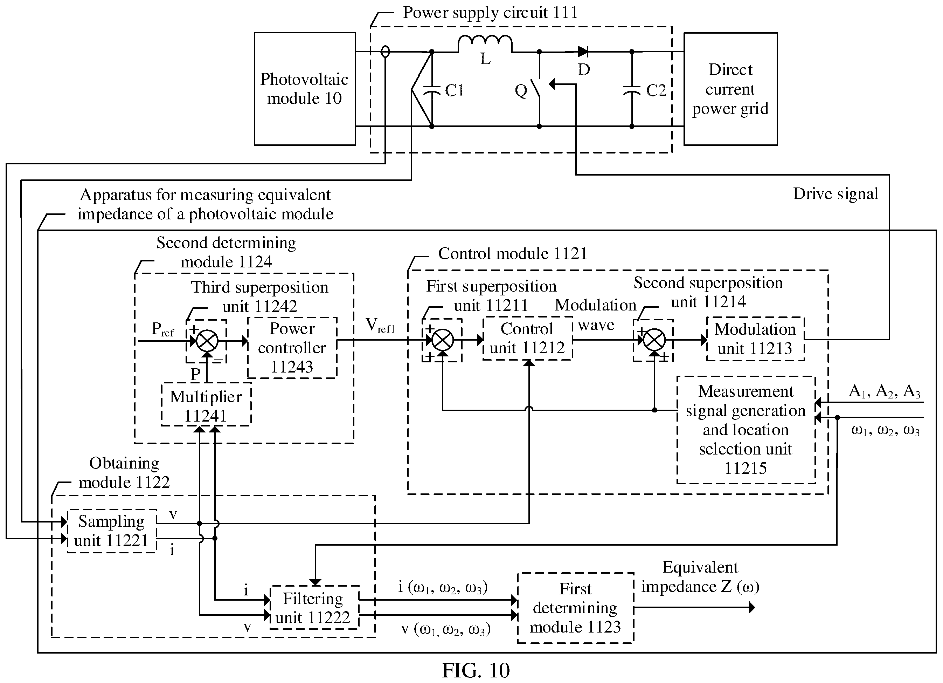

Further, the second determining module 1124 shown in FIG. 7 may further determine the first reference voltage $V_{ref1}$ existing when the DC/DC converter is in a power-limited working state. For details, refer to FIG. 10. FIG. 10 is another schematic diagram of a structure of a photovoltaic system according to this application. As shown in FIG. 10, the second determining module 1124 includes a multiplier 11241, a third superposition unit 11242, and a power controller 11243.

In an optional implementation, after the photovoltaic system 1 starts to work, the DC/DC converter is in the power-limited working state according to a received power limiting instruction. In this case, the second determining module 1124 determines a power-limited working state as the current working status of the DC/DC converter. The multiplier 11241 obtains an output voltage and an output current of the photovoltaic module 10 by using the sampling unit 11221, multiplies the obtained output voltage and the obtained output current of the photovoltaic module 10 to obtain an actual output power P of the photovoltaic module 10, and then outputs the actual output power P of the photovoltaic module 10 to the third superposition unit 11242. The third superposition unit 11242 calculates an output power error $\Delta P = P_{ref} - P$ based on the actual output power P of the photovoltaic module 10 and a reference output power $P_{ref}$, and outputs the output power error $\Delta P$ to the power controller 11243. The power controller 11243 outputs a first reference voltage $V_{ref1}$ to the first superposition unit 11211 based on the output power error $\Delta P$. The power controller 11243 herein may be a PI controller.

In addition, the measurement signal generation and location selection unit 11215 generates an alternating current measurement signal of a first frequency $\omega_1$ based on the first frequency $\omega_1$ and a first amplitude $A_1$. The control module 1121 generates a first drive signal based on the first reference voltage $V_{ref1}$ and the alternating current measurement signal of the first frequency $\omega_1$, and controls the output voltage of the photovoltaic module 10 based on the first drive signal.

The sampling unit 11221 collects an output voltage and an output current that are of the photovoltaic module 10 in a fourth time interval $\Delta t_4$ and that are controlled by the first drive signal, and outputs the output voltage and the output current of the photovoltaic module 10 in the fourth time interval $\Delta t_4$ to the filtering unit 11222. The filtering unit 11222 separately performs DFT on the output voltage and the output current of the photovoltaic module 10 in the fourth time interval $\Delta t_a$ based on the first frequency $\omega_1$, to obtain an output voltage v ($\omega_1$) and an output current i ($\omega_1$) of the photovoltaic module 10 at the first frequency $\omega_1$, and outputs the output voltage v ($\omega_1$) and the output current i ($\omega_1$) of the photovoltaic module 10 at the first frequency $\omega_1$ to the first determining module 1123. The first determining module 1123 obtains an equivalent impedance component Z ($\omega_1$)=v ($\omega_1$)/i ($\omega_1$) of the photovoltaic module 10 through calculation based on the output voltage v ($\omega_1$) and the output current i ($\omega_1$) of the photovoltaic module 10 at the first frequency $\omega_1$.

Then, the measurement signal generation and location selection unit 11215 generates an alternating current measurement signal of a second frequency $\omega_2$ based on the second frequency $\omega_2$ and a second amplitude $A_2$. The control module 1121 generates a second drive signal based on the first reference voltage $V_{ref1}$ and the alternating current measurement signal of the second frequency $\omega_2$, and controls the output voltage of the photovoltaic module 10 based on the second drive signal.

The sampling unit 11221 collects an output voltage and an output current that are of the photovoltaic module 10 in a fifth time interval $\Delta t_5$ and that are controlled by the second drive signal, and outputs the output voltage and the output current of the photovoltaic module 10 in the fifth time interval $\Delta t_5$ to the filtering unit 11222. The filtering unit 11222 separately performs DFT on the output voltage and the output current of the photovoltaic module 10 in the fifth time interval $\Delta t_5$ based on the second frequency $\omega_2$, to obtain an output voltage v ($\omega_2$) and an output current i ($\omega_2$) of the photovoltaic module 10 at the second frequency $\omega_2$, and outputs the output voltage v ($\omega_2$) and the output current i ($\omega_2$) of the photovoltaic module 10 at the second frequency $\omega_2$ to the first determining module 1123. The first determining module 1123 obtains an equivalent impedance component Z ($\omega_2$)=v ($\omega_2$)/i ($\omega_2$) of the photovoltaic module 10 through calculation based on the output voltage v ($\omega_2$) and the output current i ($\omega_2$) of the photovoltaic module 10 at the second frequency $\omega_2$.

Then, the measurement signal generation and location selection unit 11215 generates an alternating current measurement signal of a third frequency $\omega_3$ based on the third frequency $\omega_3$ and a third amplitude $A_3$. The control module 1121 generates a third drive signal based on the first reference voltage $V_{ref1}$ and the alternating current measurement signal of the third

frequency $\omega_3$, and controls the output voltage of the photovoltaic module 10 based on the third drive signal.

The sampling unit 11221 collects an output voltage and an output current that are of the photovoltaic module 10 in a sixth time interval $\Delta t_6$ and that are controlled by the third drive signal, and outputs the output voltage and the output current of the photovoltaic module 10 in the sixth time interval $\Delta t_6$ to the filtering unit 11222. The filtering unit 11222 separately performs DFT on the output voltage and the output current of the photovoltaic module 10 in the sixth time interval $\Delta t_6$ based on the third frequency $\omega_3$, to obtain an output voltage v $(\omega_3)$ and an output current i $(\omega_3)$ of the photovoltaic module 10 at the third frequency $\omega_3$, and outputs the output voltage v $(\omega_3)$ and the output current i $(\omega_3)$ of the photovoltaic module 10 at the third frequency $\omega_3$ to the first determining module 1123. The first determining module 1123 obtains an equivalent impedance component Z $(\omega_3)$=v $(\omega_3)$/i $(\omega_3)$ of the photovoltaic module 10 through calculation based on the output voltage v $(\omega_3)$ and the output current i $(\omega_3)$ of the photovoltaic module 10 at the third frequency $\omega_3$.

The first determining module 1123 obtains the equivalent impedance Z $(\omega)$ of the photovoltaic module 10 through calculation based on the equivalent impedance components Z $(\omega_1)$, Z $(\omega_2)$, and Z $(\omega_3)$.

Herein, for a specific implementation in which the control module 1121 generates the first drive signal to the third drive signal and controls the output voltage of the photovoltaic module 10 based on each of the first drive signal to the third drive signal, and the first determining module 1123 determines the equivalent impedance Z $(\omega)$ of the photovoltaic module 10 based on the equivalent impedance components Z $(\omega_1)$, Z $(\omega_2)$, and Z $(\omega_3)$, refer to descriptions of corresponding parts in the foregoing embodiment. Details are not described herein again.

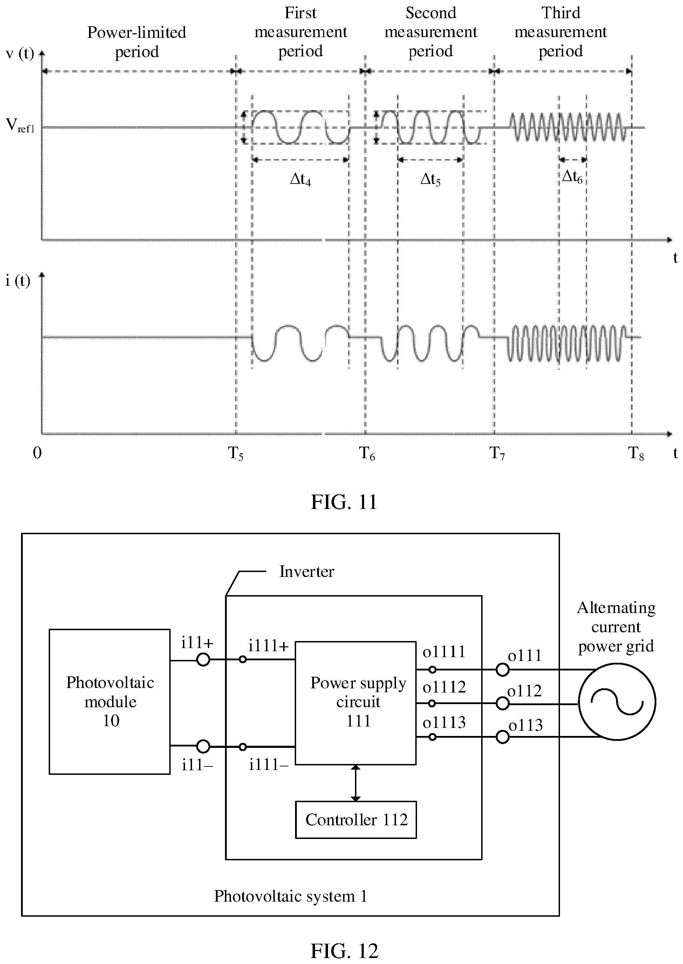

Further, refer to FIG. 11. FIG. 11 is another schematic diagram of a waveform of an output voltage and an output current of a photovoltaic module according to this application. As shown in FIG. 11, in a power-limited period 0 < t < $T_5$, after the DC/DC converter starts to run, a power-limited working state is determined as the current working status of the DC/DC converter according to a received power limiting instruction, a first reference voltage $V_{ref1}$ is determined based on an actual output power and a reference output power of the photovoltaic module 10, and it is ensured that an output voltage v (t) of the photovoltaic module 10 maintains at the first reference voltage $V_{ref1}$. After a moment $T_5$, the DC/DC converter measures equivalent impedance of the photovoltaic module 10 for the first time, controls conduction duration of the switching transistor Q based on the first drive signal, to inject an alternating current voltage of the first frequency $\omega_1$ into the photovoltaic module 10, records an output voltage v (t) and an output current i (t) of the photovoltaic module 10 in the fourth time interval $\Delta t_4$, and then obtains the equivalent impedance component Z $(\omega_1)$ of the photovoltaic module 10 through calculation based on the output voltage v (t) and output current i (t) of the photovoltaic module 10 in the fourth time interval $\Delta t_4$.

After a moment $T_6$, the DC/DC converter measures equivalent impedance of the photovoltaic module 10 for the second time, controls conduction duration of the switching transistor Q based on the second drive signal, to inject an alternating current voltage of the second frequency $\omega_2$ into the photovoltaic module 10, records an output voltage v (t) and an output current i (t) of the photovoltaic module 10 in the fifth time interval $\Delta t_5$, and then obtains the equivalent impedance component Z $(\omega_2)$ of the photovoltaic module 10 through calculation based on the output voltage v (t) and the output current i (t) of the photovoltaic module 10 in the fifth time interval $\Delta t_5$.

After a moment $T_7$, the DC/DC converter measures equivalent impedance of the photovoltaic module 10 for the third time, controls conduction duration of the switching transistor Q based on the third drive signal, to inject an alternating current voltage of the third frequency $\omega_3$ into the photovoltaic module 10, records an output voltage v (t) and an output current i (t) of the photovoltaic module 10 in the sixth time interval $\Delta t_6$, and then obtains the equivalent impedance component Z $(\omega_3)$ of the photovoltaic module 10 through calculation based on the output voltage v (t) and output current i (t) of the photovoltaic module 10 in the sixth time interval $\Delta t_6$.

After a moment $T_8$, the DC/DC converter obtains the equivalent impedance Z $(\omega)$ of the photovoltaic module 10 through calculation based on the equivalent impedance components Z $(\omega_1)$, Z $(\omega_2)$, and Z $(\omega_3)$ of the photovoltaic module 10.

In this embodiment, the DC/DC converter first controls the photovoltaic module 10 to work in the power-limited period, and the output voltage v (t) and the output current i (t) of the photovoltaic module 10 respectively maintain at the first reference voltage $V_{ref1}$ and a reference current corresponding to the first reference voltage $V_{ref1}$ for working. Then, based on this, the output voltage v (t) and the output current i (t) of the photovoltaic module 10 and the alternating current measurement signal are superposed to measure the equivalent impedance of the photovoltaic module 10. In addition, it may be learned from FIG. 11 that when the equivalent impedance of the photovoltaic module 10 is measured, the output voltage v (t) and the output current i (t) of the photovoltaic module 10 fluctuate only slightly, and average values of the output voltage and the output current of the photovoltaic module 10 still maintain close to the first reference voltage $V_{ref1}$ and the reference current that are determined in the power-unlimited period. Therefore, the photovoltaic module equivalent impedance measurement manner provided in this application causes only a small power fluctuation in the measurement process, without affecting an energy yield of the photovoltaic system 1 like the offline photovoltaic module impedance measurement manner, to implement high applicability.

Refer to FIG. 12. FIG. 12 is another schematic diagram of a structure of a photovoltaic system according to this application. As shown in FIG. 12, the photovoltaic system 1 includes the photovoltaic module 10 and an inverter. The photovoltaic module 10 is connected to an alternating current power grid through the inverter. In the photovoltaic system 1 shown in FIG. 12, the photovoltaic power generation device 11 provided in this application is the inverter. The inverter includes a power supply circuit 111 and a controller 112. Two input ends i111+ and i111- of the power supply circuit 111 are respectively connected to two input ends i11+ and i11- of the inverter. Three output ends o1111, o1112, and o1113 of the power supply circuit 111 are respectively connected to three output ends o111, o112, and o113 of the inverter. The power supply circuit 111 herein is an inverter circuit. The inverter circuit includes a first phase bridge arm, a second phase bridge arm, and a third phase bridge arm. The first phase bridge arm, the second phase bridge arm, and the third phase bridge arm are all connected in parallel to an input end of the inverter circuit.

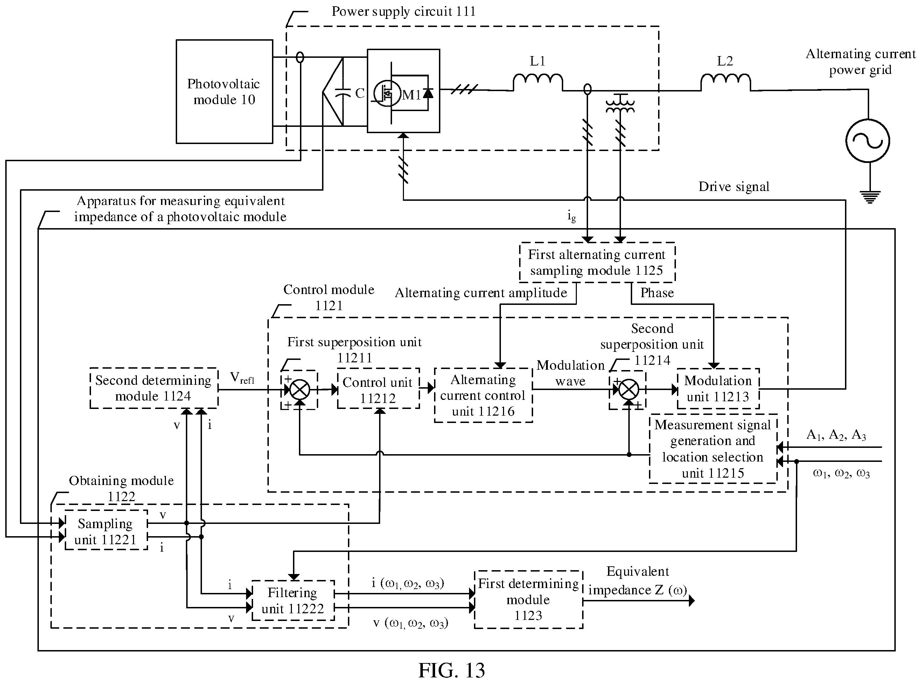

Further, the photovoltaic system shown in FIG. 12 may be equivalent to a photovoltaic system shown in FIG. 13. As shown in FIG. 13, an apparatus for measuring equivalent impedance of a photovoltaic module in FIG. 13 is corresponding to the controller 112 in FIG. 12. In addition, to simplify description, a simplified representation method is used for a three-phase alternating current variable. To be specific, three short slashes indicate that the variable or an electrical variable is a three-phase variable. For example, an alternating current $i_g$ in FIG. 13 actually includes three-phase current information of a phase A, a phase B, and a phase C. In addition, because an output end of the photovoltaic system 1 in this embodiment is connected to the alternating current power grid, compared with the apparatus for measuring equivalent impedance shown in FIG. 7, the apparatus for measuring equivalent impedance in this embodiment further includes a first alternating current sampling module 1125, and further includes an alternating current control unit 11216.

The first alternating current sampling module 1125 is configured to collect an alternating current amplitude of the alternating current $i_g$ and a phase of an alternating current voltage of an output port of the power supply circuit 111. The alternating current control unit 11216 is configured to control the amplitude of the alternating current of the output port of the power supply circuit 111, to ensure an appropriate power generation function of the photovoltaic system 1. The modulation unit 11213 is further configured to convert a control variable of a direct current end into an electrical variable that matches an alternating current port.

The following describes in detail the alternating current control unit 11216 and the modulation unit 11213 by using an example in which a first drive signal (including a first drive subsignal, a second drive subsignal, and a third drive subsignal) is generated based on a first reference voltage $V_{ref1}$ and an alternating current measurement signal of a first frequency $\omega_1$ ($\omega_1$ is less than $\omega_b$).

The first superposition unit 11211 superposes the first reference voltage $V_{ref1}$ and the alternating current measurement signal of the first frequency $\omega_1$ to obtain a second reference voltage $V_{ref2}$, and outputs the second reference voltage $V_{ref2}$ to the control unit 11212. The control unit 11212 generates a first modulation wave based on the second reference voltage $V_{ref2}$ and a current output voltage v ($t_1$) of the photovoltaic module 10, and outputs the first modulation wave to the alternating current control unit 11216. The alternating current control unit 11216 adjusts an amplitude of the first modulation wave based on the collected alternating current amplitude and a reference alternating current amplitude, to obtain an adjusted first modulation wave, to ensure an appropriate power generation function of the photovoltaic system 1. The alternating current control unit 11216 outputs the modulated first modulation wave to the second superposition unit 11214. The second superposition unit 11214 outputs the adjusted first modulation wave to the modulation unit 11213. The modulation unit 11213 generates the first drive signal based on the adjusted first modulation wave, and performs phase translation on the first drive subsignal based on a phase of the alternating current voltage, to obtain the second drive subsignal and the third drive subsignal. The first drive subsignal is used to control conduction duration of a switching transistor of the first phase bridge arm in the power supply circuit 111, the second drive subsignal is used to control conduction duration of a switching transistor of the second phase bridge arm in the power supply circuit 111, and the third drive subsignal is used to control conduction duration of a switching transistor of the third phase bridge arm in the power supply circuit 111. The switching transistors from the first phase bridge arm to the third phase bridge arm may be switching transistors located on an upper side or a lower side in each phase bridge arm. In a same phase bridge arm, a drive subsignal of a switching transistor located on an upper side is complementary to a drive subsignal of a switching transistor located on a lower side.

In addition, when equivalent impedance of the photovoltaic module 10 is measured, for a specific process performed by another module and another unit in the apparatus for measuring equivalent impedance, refer to descriptions of corresponding parts in the embodiments in FIG. 7 and FIG. 10. Details are not described herein again.

In this embodiment, on the basis that the output voltage and the output current of the photovoltaic module 10 respectively maintain at the first reference voltage $V_{ref1}$ and the reference current corresponding to the first reference voltage $V_{ref1}$ for working, the inverter superposes the alternating current measurement signal on the output voltage and the output current of the photovoltaic module 10, to measure the equivalent impedance of the photovoltaic module 10. Therefore, the equivalent impedance of the photovoltaic module 10 is measured, without affecting an energy yield of the photovoltaic system 1,

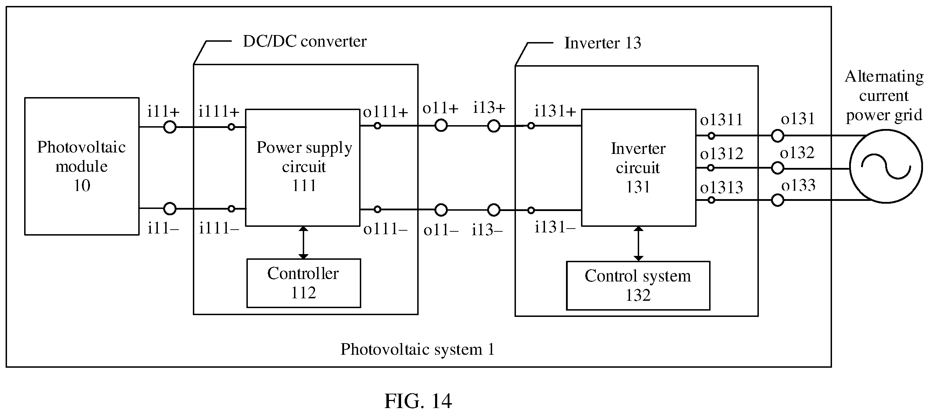

Refer to FIG. 14. FIG. 14 is another schematic diagram of a structure of a photovoltaic system according to this application. As shown in FIG. 14, the photovoltaic system 1 includes the photovoltaic module 10, a DC/DC converter, and an inverter 13. Two input ends i11+ and i11- of the DC/DC converter are connected to the photovoltaic module 10. Two output ends o11+ and o11- of the DC/DC converter are respectively connected to two input ends i13+ and i13- of the inverter 13. Three output ends o131, o132, and o133 of the inverter 13 are connected to an alternating current power grid. In the photovoltaic system 1 shown in FIG. 14, the photovoltaic power generation device 11 provided in this application is the DC/DC converter. The DC/DC converter includes a power supply circuit 111 and a controller 112. Two input ends i111+ and i111-of the power supply circuit 111 are respectively connected to two input ends i11+ and i11- of the DC/DC converter. Two output ends o111+ and o111- of the power supply circuit 111 are respectively connected to two output ends o11+ and o11- of the DC/DC converter. The inverter 13 includes an inverter circuit 131 and a control system 132. Two input ends i131+ and i131- of the inverter circuit 131 are respectively connected to two input ends i13+ and i13- of the inverter 13. Three output ends o1311, o1312, and o1313 of the inverter circuit 131 are respectively connected to three output ends o131, o132, and o133 of the inverter 13.

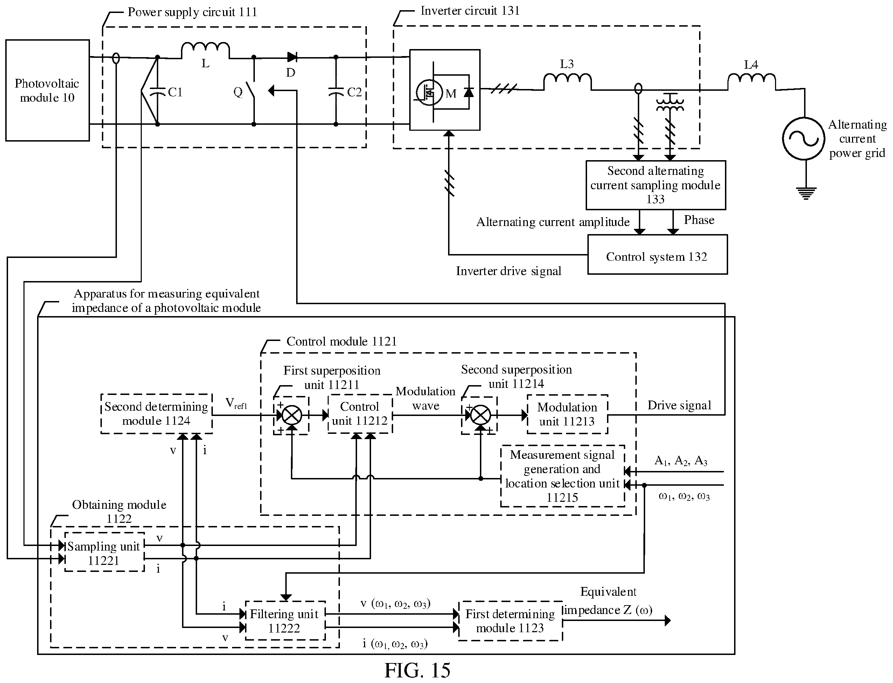

If the power supply circuit 111 is a Boost circuit, the photovoltaic system shown in FIG. 14 may also be equivalent to a photovoltaic system shown in FIG. 15. As shown in FIG. 15, the inverter 13 further includes a second alternating current sampling module 133. After the photovoltaic system 1 starts to run, the control system 132 obtains an amplitude of an alternating current and a phase of an alternating current voltage of an output port of the inverter circuit 131 by using the second alternating current sampling module 133, and generates an inverter drive signal based on the amplitude of the alternating current and the phase of the alternating current voltage. The inverter drive signal is used to control conduction duration of the switching transistors of the three phase bridge arms in the inverter circuit 131, so that the inverter 13 outputs, to the alternating current power grid, an alternating current that meets a requirement of the alternating current power grid.

Compared with the DC/DC converter shown in FIG. 6, the DC/DC converter in this embodiment is not directly connected to the power grid, but the inverter 13 is added at the back end to be connected to the alternating current power grid. The inverter 13 has the independent control system 132. The inverter 13 at the back end functions to provide a stable output alternating current voltage, without affecting the DC/DC converter at the front end. Therefore, for a specific implementation process of measuring the equivalent impedance of the photovoltaic module 10 in this embodiment, refer to the descriptions in the embodiments corresponding to FIG.

6, FIG. 7, and FIG. 10. Details are not described herein again.

In this embodiment, on the basis that the output voltage and the output current of the photovoltaic module 10 respectively maintain at the first reference voltage $V_{ref1}$ and the reference current corresponding to the first reference voltage $V_{ref1}$ for working, the DC/DC converter superposes the alternating current measurement signal on the output voltage and the output current of the photovoltaic module 10, to measure the equivalent impedance of the photovoltaic module 10. Therefore, the equivalent impedance of the photovoltaic module 10 is measured, without affecting an energy yield of the photovoltaic system 1, to implement high applicability.

It may be understood that the photovoltaic power generation device 11 may superpose the alternating current measurement signal on the output voltage and the output current of the photovoltaic module 10 based on appropriate power supply to the power grid to measure the equivalent impedance of the photovoltaic module 10, without affecting an energy yield of the photovoltaic system 1, to implement high applicability.

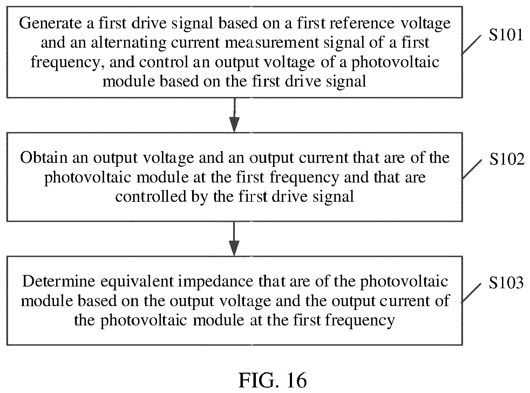

Refer to FIG. 16. FIG. 16 is a schematic flowchart of a method for measuring equivalent impedance of a photovoltaic module according to this application. The method for measuring equivalent impedance of a photovoltaic module provided in this embodiment of this application is applicable to the apparatuses for measuring equivalent impedance of a photovoltaic module in the photovoltaic system 1 shown in FIG. 4, FIG. 5, FIG. 7, FIG. 10, FIG. 13, and FIG. 15. The method for measuring equivalent impedance of a photovoltaic module may include the following steps.

S101: Generate a first drive signal based on a first reference voltage and an alternating current measurement signal of a first frequency, and control an output voltage of a photovoltaic module based on the first drive signal.

The first reference voltage is a reference input voltage of a photovoltaic power generation device in a state of supplying power to a power grid.

In an optional implementation, the apparatus for measuring equivalent impedance generates a first drive signal based on the first reference voltage and the alternating current measurement signal of the first frequency, and controls an output voltage of the photovoltaic module based on the first drive signal.

In another optional implementation, the apparatus for measuring equivalent impedance generates a first drive signal based on the first reference voltage and alternating current measurement signals of at least two different frequencies, and controls the output voltage of the photovoltaic module based on the first drive signal, where the at least two different frequencies include the first frequency.

In still another optional implementation, the apparatus for measuring equivalent impedance separately generates at least two drive signals based on the first reference voltage and the at least two alternating current measurement signals of the at least two different frequencies, and controls the output voltage of the photovoltaic module based on each of the at least two drive signals. The at least two alternating current measurement signals of the at least two frequencies include the alternating current measurement signal of the first frequency. The at least two drive signals include the first drive signal.

S102: Obtain an output voltage and an output current that are of the photovoltaic module at the first frequency and that are controlled by the first drive signal.

In an optional implementation, the apparatus for measuring equivalent impedance obtains the output voltage and the output current that are of the photovoltaic module at the first frequency and that are controlled by the first drive signal.

In another optional implementation, the apparatus for measuring equivalent impedance obtains an output voltage and an output current that are of the photovoltaic module at each of the at least two different frequencies and that are controlled by the first drive signal.

In still another optional implementation, the apparatus for measuring equivalent impedance obtains an output voltage and an output current that are of the photovoltaic module at a frequency corresponding to each drive signal and that are controlled by each of the at least two drive signals, where the frequency corresponding to the first drive signal is the first frequency.

S103: Determine equivalent impedance of the photovoltaic module based on the output voltage and the output current of the photovoltaic module at the first frequency.

In an optional implementation, the apparatus for measuring equivalent impedance obtains equivalent impedance $Z(\omega)=v(\omega_1)/i(\omega_1)$ of the photovoltaic module based on the output voltage $v(\omega_1)$ and the output current $i(\omega_1)$ of the photovoltaic module at the first frequency $\omega_1$.

In another optional implementation, the apparatus for measuring equivalent impedance obtains the equivalent impedance of the photovoltaic module through calculation based on the output voltage and the output current of the photovoltaic module at each of the at least two different frequencies.

In a specific implementation, for more operations performed by the equivalent impedance measurement apparatus in the method for measuring equivalent impedance of a photovoltaic module provided in this application, refer to implementations performed by the apparatus for measuring equivalent impedance in the photovoltaic system 1 shown in FIG. 4, FIG. 5, FIG. 7, FIG. 10, FIG. 13, and FIG. 15. Details are not described herein again.

In this embodiment, the apparatus for measuring equivalent impedance of a photovoltaic module may superpose the alternating current measurement signal on the output voltage and the output current of the photovoltaic module 10 based on appropriate power supply to the power grid to measure the equivalent impedance of the photovoltaic module 10, without affecting an energy yield of the photovoltaic system 1, to implement high applicability.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A method for measuring equivalent impedance of a photovoltaic module, wherein the photovoltaic module (10) is connected to an input end of a photovoltaic power generation device (11), an output end of the photovoltaic power generation device is connected to a power grid, and the method comprises:

   generating a first drive signal based on a first reference voltage and an alternating current measurement signal of a first frequency, and controlling an output voltage of the photovoltaic module based on the first drive signal, wherein the first reference voltage is a reference input voltage of the photovoltaic power generation device in a state of supplying power to the power grid;
   obtaining an output voltage and an output current that are of the photovoltaic module at the first frequency and that are controlled by the first drive signal; and
   determining the equivalent impedance of the photovoltaic module based on the output voltage and the output current of the photovoltaic module at the first frequency.

2. The method according to claim 1, wherein the generating a first drive signal based on a first reference voltage and an alternating current measurement signal of a first frequency comprises:

   superposing the first reference voltage and the alternating current measurement signal to obtain a second reference voltage; and
   generating a first modulation wave based on the second reference voltage and a current output voltage of the photovoltaic module, and generating the first drive signal based on the first modulation wave.

3. The method according to claim 1, wherein the generating a first drive signal based on a first reference voltage and an alternating current measurement signal of a first frequency comprises:

generating a second modulation wave based on the first reference voltage and a current output voltage of the photovoltaic module; and superposing the second modulation wave and the alternating current measurement signal to obtain a third modulation wave, and generating the first drive signal based on the third modulation wave.

4. The method according to any one of claims 1 to 3, wherein the obtaining an output voltage and an output current of the photovoltaic module at the first frequency under control of the first drive signal comprises:
collecting an output voltage and an output current that are of the photovoltaic module and that are controlled by the first drive signal, and performing frequency domain filtering on the sampled output voltage and the sampled output current of the photovoltaic module based on the first frequency, to obtain the output voltage and the output current of the photovoltaic module at the first frequency.

5. The method according to any one of claims 1 to 4, wherein the generating a first drive signal based on a first reference voltage and an alternating current measurement signal of a first frequency comprises:

generating the first drive signal based on the first reference voltage and alternating current measurement signals of at least two different frequencies, wherein the at least two different frequencies comprise the first frequency and a second frequency;
the obtaining an output voltage and an output current that are of the photovoltaic module at the first frequency and that are controlled by the first drive signal comprises:

obtaining the output voltage and the output current that are of the photovoltaic module at the first frequency and that are controlled by the first drive signal, and an output voltage and an output current of the photovoltaic module at the second frequency; and the determining the equivalent impedance of the photovoltaic module based on the output voltage and the output current of the photovoltaic module at the first frequency comprises:
determining the equivalent impedance of the photovoltaic module based on the output voltage and the output current of the photovoltaic module at the first frequency and the output voltage and the output current of the photovoltaic module at the second frequency.

6. The method according to claim 5, wherein each of the at least two different frequencies is less than a frequency threshold, or each of the at least two different frequencies is greater than or equal to a frequency threshold.

7. The method according to any one of claims 1 to 4, wherein the method comprises:

generating a second drive signal based on the first reference voltage and an alternating current measurement signal of a second frequency, and controlling the output voltage of the photovoltaic module based on the second drive signal; and obtaining an output voltage and an output current that are of the photovoltaic module at the second frequency and that are controlled by the second drive signal; and the determining the equivalent impedance of the photovoltaic module based on the output voltage and the output current of the photovoltaic module at the first frequency comprises:
determining the equivalent impedance of the photovoltaic module based on the output voltage and the output current of the photovoltaic module at the first frequency and the output voltage and the output current of the photovoltaic module at the second frequency.

8. The method according to claim 5 or 7, wherein the determining the equivalent impedance of the photovoltaic module based on the output voltage and the output current of the photovoltaic module at the first frequency and the output voltage and the output current of the photovoltaic module at the second frequency comprises:

determining an equivalent impedance component of the photovoltaic module at the first frequency based on the output voltage and the output current of the photovoltaic module at the first frequency, and determining an equivalent impedance component of the photovoltaic module at the second frequency based on the output voltage and the output current of the photovoltaic module at the second frequency; and
determining the equivalent impedance of the photovoltaic module based on the equivalent impedance component of the photovoltaic module at the first frequency and the equivalent impedance component of the photovoltaic module at the second frequency.

9. The method according to any one of claims 1 to 8, wherein the method comprises:
determining a current working status of the photovoltaic power generation device, and determining the first reference voltage based on the current working status of the photovoltaic power generation device, wherein the first reference voltage is a reference input voltage of the photovoltaic power generation device in a power-limited working state, or a reference input voltage of the photovoltaic power generation device in a power-unlimited working state.

10. A photovoltaic power generation device (11), wherein an input end of the photovoltaic power generation device is connected to a photovoltaic module (10), an output end of the photovoltaic power generation device is connected to a power grid, and the photovoltaic power generation device comprises a controller (112) and a power supply circuit (111);

an input end of the power supply circuit is connected to the input end of the photovoltaic power generation device, an output end of the power supply circuit is connected to the output end of the photovoltaic power generation device, and the power supply circuit is configured to convert an output voltage of the photovoltaic module into an output voltage of the photovoltaic power generation device in a state of supplying power to the power grid; and
the controller is configured to: generate a first drive signal based on a first reference voltage and an alternating current measurement signal of a first frequency, and control an output voltage of the photovoltaic module based on the first drive signal, wherein the first reference voltage is a reference input voltage of the photovoltaic power generation device in the state of supplying power to the power grid; obtain an output voltage and an output current that are of the photovoltaic module at the first frequency and that are controlled by the first drive signal; and determine equivalent impedance of the photovoltaic module based on the output voltage and the output current of the photovoltaic module at the first frequency.

11. The photovoltaic power generation device according to claim 10, wherein the controller is configured to: superpose the first reference voltage and the alternating current measurement signal to obtain a second reference voltage; and generate a first modulation wave based on the second reference voltage and a current output voltage of the photovoltaic module, and generate the first drive signal based on the first modulation wave.

12. The photovoltaic power generation device according to claim 10, wherein the controller is configured to: generate a second modulation wave based on the first reference voltage and a current output voltage of the photovoltaic module; and superpose the second modulation wave and the alternating current measurement signal to obtain a third modulation wave, and generate the first drive signal based on the third modulation wave.

13. The photovoltaic power generation device according to any one of claims 10 to 12, wherein the controller is configured to collect an output voltage and an output current that are of the photovoltaic module and that are controlled by the first drive signal, and perform frequency domain filtering on the output voltage and the output current of the photovoltaic module based on the first frequency, to obtain the output voltage and the output current of the photovoltaic module at the first frequency.

14. The photovoltaic power generation device according to any one of claims 10 to 13, wherein the controller is configured to generate the first drive signal based on the first reference voltage and alternating current measurement signals of at least two different frequencies, wherein the at least two different frequencies comprise the first frequency and a second frequency; and
the controller is configured to: obtain the output voltage and the output current that are of the photovoltaic module at the first frequency and that are controlled by the first drive signal, and an output voltage and an output current of the photovoltaic module at the second frequency; and determine the equivalent impedance of the photovoltaic module based on the output voltage and the output current of the photovoltaic module at the first frequency and the output voltage and the output current of the photovoltaic module at the second frequency.

15. The photovoltaic power generation device according to claim 14, wherein each of the at least two different frequencies is less than a frequency threshold, or each of the at least two different frequencies is greater than or equal to a frequency threshold.

**Patentansprüche**

1. Verfahren zum Messen einer äquivalenten Impedanz eines Photovoltaikmoduls, wobei das Photovoltaikmodul (10) mit einem Eingangsende einer Photovoltaikstromerzeugungsvorrichtung (11) verbunden ist, ein Ausgangsende der Photovoltaikstromerzeugungsvorrichtung mit einem Stromnetz verbunden ist und das Verfahren umfasst:

Erzeugen eines ersten Ansteuersignals basierend auf einer ersten Referenzspannung und einem Wechselstrommesssignal einer ersten Frequenz und Steuern einer Ausgangsspannung des Photovoltaikmoduls basierend auf dem ersten Ansteuersignal, wobei die erste Referenzspannung eine Referenzeingangsspannung der Photovoltaikstromerzeugungsvorrichtung in einem Zustand einer Stromversorgung in das Stromnetz ist;

Erhalten einer Ausgangsspannung und eines Ausgangsstroms, die von dem Photovoltaikmodul stammen, bei der ersten Frequenz und die durch das erste Ansteuersignal gesteuert werden; und

Bestimmen der äquivalenten Impedanz des Photovoltaikmoduls basierend auf der Ausgangsspannung und dem Ausgangsstrom des Photovoltaikmoduls bei der ersten Frequenz.

2. Verfahren nach Anspruch 1, wobei das Erzeugen eines ersten Ansteuersignals basierend auf einer ersten Referenzspannung und einem Wechselstrommesssignal einer ersten Frequenz umfasst:

Überlagern der ersten Referenzspannung und des Wechselstrommesssignals, um eine zweite Referenzspannung zu erhalten; und
Erzeugen einer ersten Modulationswelle basierend auf der zweiten Referenzspannung und einer aktuellen Ausgangsspannung des Photovoltaikmoduls und Erzeugen des ersten Ansteuersignals basierend auf der ersten Modulationswelle.

3. Verfahren nach Anspruch 1, wobei das Erzeugen eines ersten Ansteuersignals basierend auf einer ersten Referenzspannung und einem Wechselstrommesssignal einer ersten Frequenz umfasst:

Erzeugen einer zweiten Modulationswelle basierend auf der ersten Referenzspannung und einer aktuellen Ausgangsspannung des Photovoltaikmoduls; und
Überlagern der zweiten Modulationswelle und des Wechselstrommesssignals, um eine dritte Modulationswelle zu erhalten, und Erzeugen des ersten Ansteuersignals basierend auf der dritten Modulationswelle.

4. Verfahren nach einem der Ansprüche 1 bis 3, wobei das Erhalten einer Ausgangsspannung und eines Ausgangsstroms des Photovoltaikmoduls bei der ersten Frequenz unter Steuerung des ersten Ansteuersignals umfasst:
Erfassen einer Ausgangsspannung und eines Ausgangsstroms, die von dem Photovoltaikmodul stammen und die durch das erste Ansteuersignal gesteuert werden, und Durchführen einer Frequenzbereichsfilterung an der abgetasteten Ausgangsspannung und dem abgetasteten Ausgangsstrom des Photovoltaikmoduls basierend auf der ersten Frequenz, um die Ausgangsspannung und den Ausgangsstrom des Photovoltaikmoduls bei der ersten Frequenz zu erhalten.

5. Verfahren nach einem der Ansprüche 1 bis 4, wobei das Erzeugen eines ersten Ansteuersignals basierend auf einer ersten Referenzspannung und einem Wechselstrommesssignal einer ersten Frequenz umfasst:

Erzeugen des ersten Ansteuersignals basierend auf der ersten Referenzspannung und Wechselstrommesssignalen mit mindestens zwei unterschiedlichen Frequenzen, wobei die mindestens zwei unterschiedlichen Frequenzen die erste Frequenz und eine zweite Frequenz umfassen;
das Erhalten einer Ausgangsspannung und eines Ausgangsstroms, die von dem Photovoltaikmodul stammen, bei der ersten Frequenz und die durch das erste Ansteuersignal gesteuert werden, umfasst:

Erhalten der Ausgangsspannung und des Ausgangsstroms, die von dem Photovoltaikmodul stammen, bei der ersten Frequenz und die durch das erste Ansteuersignal gesteuert werden, und einer Ausgangsspannung und eines Ausgangsstroms des Photovoltaikmoduls bei der zweiten Frequenz; und
das Bestimmen der äquivalenten Impedanz des Photovoltaikmoduls basierend auf der Ausgangsspannung und dem Ausgangsstrom des Photovoltaikmoduls bei der ersten Frequenz umfasst:
Bestimmen der äquivalenten Impedanz des Photovoltaikmoduls basierend auf der Ausgangsspannung und dem Ausgangsstrom des Photovoltaikmoduls bei der ersten Frequenz und der Ausgangsspannung und dem Ausgangsstrom des Photovoltaikmoduls bei der zweiten Frequenz.

6. Verfahren nach Anspruch 5, wobei jede der mindestens zwei unterschiedlichen Frequenzen kleiner als ein Frequenzschwellenwert ist oder jede der mindestens zwei unterschiedlichen Frequenzen größer als oder gleich einem Frequenzschwellenwert ist.

7. Verfahren nach einem der Ansprüche 1 bis 4, wobei das Verfahren umfasst:

Erzeugen eines zweiten Ansteuersignals basierend auf der ersten Referenzspannung und einem Wechselstrommesssignal einer zweiten Frequenz und Steuern der Ausgangsspannung des Photovoltaikmoduls basierend auf dem zweiten Ansteuersignal; und

Erhalten einer Ausgangsspannung und eines Ausgangsstroms, die von dem Photovoltaikmodul stammen, bei der zweiten Frequenz und die durch das zweite Ansteuersignal gesteuert werden; und

das Bestimmen der äquivalenten Impedanz des Photovoltaikmoduls basierend auf der Ausgangsspannung und dem Ausgangsstrom des Photovoltaikmoduls bei der ersten Frequenz umfasst:

Bestimmen der äquivalenten Impedanz des Photovoltaikmoduls basierend auf der Ausgangsspannung und dem Ausgangsstrom des Photovoltaikmoduls bei der ersten Frequenz und der Ausgangsspannung und dem Ausgangsstrom des Photovoltaikmoduls bei der zweiten Frequenz.

8. Verfahren nach Anspruch 5 oder 7, wobei das Bestimmen der äquivalenten Impedanz des Photovoltaikmoduls basierend auf der Ausgangsspannung und dem Ausgangsstrom des Photovoltaikmoduls bei der ersten Frequenz und der Ausgangsspannung und dem Ausgangsstrom des Photovoltaikmoduls bei der zweiten Frequenz umfasst:

Bestimmen einer äquivalenten Impedanzkomponente des Photovoltaikmoduls bei der ersten Frequenz basierend auf der Ausgangsspannung und dem Ausgangsstrom des Photovoltaikmoduls bei der ersten Frequenz und Bestimmen einer äquivalenten Impedanzkomponente des Photovoltaikmoduls bei der zweiten Frequenz basierend auf der Ausgangsspannung und dem Ausgangsstrom des Photovoltaikmoduls bei der zweiten Frequenz; und

Bestimmen der äquivalenten Impedanz des Photovoltaikmoduls basierend auf der äquivalenten Impedanzkomponente des Photovoltaikmoduls bei der ersten Frequenz und der äquivalenten Impedanzkomponente des Photovoltaikmoduls bei der zweiten Frequenz.

9. Verfahren nach einem der Ansprüche 1 bis 8, wobei das Verfahren umfasst:
Bestimmen eines aktuellen Betriebszustands der Photovoltaikstromerzeugungsvorrichtung und Bestimmen der ersten Referenzspannung basierend auf dem aktuellen Betriebszustand der Photovoltaikstromerzeugungsvorrichtung, wobei die erste Referenzspannung eine Referenzeingangsspannung der Photovoltaikstromerzeugungsvorrichtung in einem leistungsbegrenzten Betriebszustand oder eine Referenzeingangsspannung der Photovoltaikstromerzeugungsvorrichtung in einem leistungsunbegrenzten Betriebszustand ist.

10. Photovoltaikstromerzeugungsvorrichtung (11),

wobei ein Eingangsende der Photovoltaikstromerzeugungsvorrichtung mit einem Photovoltaikmodul (10) verbunden ist,
ein Ausgangsende der Photovoltaikstromerzeugungsvorrichtung mit einem Stromnetz verbunden ist und die Photovoltaikstromerzeugungsvorrichtung eine Steuerung (112) und eine Stromversorgungsschaltung (111) umfasst;
ein Eingangsende der Stromversorgungsschaltung mit dem Eingangsende der Photovoltaikstromerzeugungsvorrichtung verbunden ist, ein Ausgangsende der Stromversorgungsschaltung mit dem Ausgangsende der Photovoltaikstromerzeugungsvorrichtung verbunden ist und die Stromversorgungsschaltung konfiguriert ist, um eine Ausgangsspannung des Photovoltaikmoduls in eine Ausgangsspannung der Photovoltaikstromerzeugungsvorrichtung in einem Zustand der Stromversorgung in das Stromnetz umzuwandeln; und
die Steuerung konfiguriert ist zum: Erzeugen eines ersten Ansteuersignals basierend auf einer ersten Referenzspannung und einem Wechselstrommesssignal einer ersten Frequenz und Steuern einer Ausgangsspannung des Photovoltaikmoduls basierend auf dem ersten Ansteuersignal, wobei die erste Referenzspannung eine Referenzeingangsspannung der Photovoltaikstromerzeugungsvorrichtung in dem Zustand der Stromversorgung in das Stromnetz ist; Erhalten einer Ausgangsspannung und eines Ausgangsstroms, die von dem Photovoltaikmodul stammen, bei der ersten Frequenz und die durch das erste Ansteuersignal gesteuert werden; und Bestimmen der äquivalenten Impedanz des Photovoltaikmoduls basierend auf der Ausgangsspannung und dem Ausgangsstrom des Photovoltaikmoduls bei der ersten Frequenz.

11. Photovoltaikstromerzeugungsvorrichtung nach Anspruch 10, wobei die Steuerung konfiguriert ist zum: Überlagern der ersten Referenzspannung und des Wechselstrommesssignals, um eine zweite Referenzspannung zu erhalten; und Erzeugen einer ersten Modulationswelle basierend auf der zweiten Referenzspannung und einer aktuellen Ausgangsspannung des Photovoltaikmoduls und Erzeugen des ersten Ansteuersignals basierend auf der ersten Modulationswelle.

12. Photovoltaikstromerzeugungsvorrichtung nach Anspruch 10, wobei die Steuerung konfiguriert ist zum:

Erzeugen einer zweiten Modulationswelle basierend auf der ersten Referenzspannung und einer aktuellen Ausgangsspannung des Photovoltaikmoduls; und Überlagern der zweiten Modulationswelle und des Wechselstrommesssignals, um eine dritte Modulationswelle zu erhalten, und Erzeugen des ersten Ansteuersignals basierend auf der dritten Modulationswelle.

13. Photovoltaikstromerzeugungsvorrichtung nach einem der Ansprüche 10 bis 12, wobei die Steuerung konfiguriert ist, um eine Ausgangsspannung und einen Ausgangsstrom, die von dem Photovoltaikmodul stammen und die durch das erste Ansteuersignal gesteuert werden, zu erfassen, und die Frequenzbereichsfilterung an der Ausgangsspannung und dem Ausgangsstrom des Photovoltaikmoduls basierend auf der ersten Frequenz durchzuführen, um die Ausgangsspannung und den Ausgangsstrom des Photovoltaikmoduls bei der ersten Frequenz zu erhalten.

14. Photovoltaikstromerzeugungsvorrichtung nach einem der Ansprüche 10 bis 13, wobei die Steuerung konfiguriert ist, um das erste Ansteuersignal basierend auf der ersten Referenzspannung und Wechselstrommesssignalen mit mindestens zwei unterschiedlichen Frequenzen zu erzeugen, wobei die mindestens zwei unterschiedlichen Frequenzen die erste Frequenz und eine zweite Frequenz umfassen; und die Steuerung konfiguriert ist zum: Erhalten der Ausgangsspannung und des Ausgangsstroms, die von dem Photovoltaikmodul stammen, bei der ersten Frequenz und die durch das erste Ansteuersignal gesteuert werden, und einer Ausgangsspannung und eines Ausgangsstroms des Photovoltaikmoduls bei der zweiten Frequenz; und Bestimmen der äquivalente Impedanz des Photovoltaikmoduls basierend auf der Ausgangsspannung und dem Ausgangsstrom des Photovoltaikmoduls bei der ersten Frequenz und der Ausgangsspannung und dem Ausgangsstrom des Photovoltaikmoduls bei der zweiten Frequenz.

15. Photovoltaikstromerzeugungsvorrichtung nach Anspruch 14, wobei jede der mindestens zwei unterschiedlichen Frequenzen kleiner als ein Frequenzschwellenwert ist oder jede der mindestens zwei unterschiedlichen Frequenzen größer als oder gleich einem Frequenzschwellenwert ist.

**Revendications**

1. Procédé permettant de mesurer une impédance équivalente d'un module photovoltaïque, dans lequel le module photovoltaïque (10) est connecté à une extrémité d'entrée d'un dispositif de production d'énergie photovoltaïque (11), une extrémité de sortie du dispositif de production d'énergie photovoltaïque est connectée à un réseau électrique, et le procédé comprend :

la génération d'un premier signal d'attaque sur la base d'une première tension de référence et d'un signal de mesure de courant alternatif d'une première fréquence, et la commande d'une tension de sortie du module photovoltaïque sur la base du premier signal d'attaque, dans lequel la première tension de référence est une tension d'entrée de référence du dispositif de production d'énergie photovoltaïque dans un état d'alimentation en énergie vers le réseau électrique ;
l'obtention d'une tension de sortie et d'un courant de sortie qui appartiennent au module photovoltaïque à la première fréquence et qui sont commandés par le premier signal d'attaque ; et
la détermination de l'impédance équivalente du module photovoltaïque sur la base de la tension de sortie et du courant de sortie du module photovoltaïque à la première fréquence.

2. Procédé selon la revendication 1, dans lequel la génération d'un premier signal d'attaque sur la base d'une première tension de référence et d'un signal de mesure de courant alternatif d'une première fréquence comprend :

la superposition de la première tension de référence et du signal de mesure de courant alternatif pour obtenir une seconde tension de référence ; et
la génération d'une première onde de modulation sur la base de la seconde tension de référence et d'une tension de sortie de courant du module photovoltaïque, et la génération du premier signal d'attaque sur la base de la première onde de modulation.

3. Procédé selon la revendication 1, dans lequel la génération d'un premier signal d'attaque sur la base d'une première tension de référence et d'un signal de mesure de courant alternatif d'une première fréquence comprend :

la génération d'une deuxième onde de modulation sur la base de la première tension de référence et d'une tension de sortie de courant du module photovoltaïque ; et
la superposition de la deuxième onde de modulation et du signal de mesure de courant alternatif pour obtenir une troisième onde de modulation, et la génération du premier signal d'attaque sur la base de la troisième onde de modulation.

**4.** Procédé selon l'une quelconque des revendications 1 à 3, dans lequel l'obtention d'une tension de sortie et d'un courant de sortie du module photovoltaïque à la première fréquence sous la commande du premier signal d'attaque comprend :
la collecte d'une tension de sortie et d'un courant de sortie qui appartiennent au module photovoltaïque et qui sont commandés par le premier signal d'attaque, et la réalisation d'un filtrage dans le domaine fréquentiel sur la tension de sortie échantillonnée et le courant de sortie échantillonné du module photovoltaïque sur la base de la première fréquence, pour obtenir la tension de sortie et le courant de sortie du module photovoltaïque à la première fréquence.

**5.** Procédé selon l'une quelconque des revendications 1 à 4, dans lequel la génération d'un premier signal d'attaque sur la base d'une première tension de référence et d'un signal de mesure de courant alternatif d'une première fréquence comprend :

la génération du premier signal d'attaque sur la base de la première tension de référence et de signaux de mesure de courant alternatif d'au moins deux fréquences différentes, dans lequel les au moins deux fréquences différentes comprennent la première fréquence et une seconde fréquence ;
l'obtention d'une tension de sortie et d'un courant de sortie qui appartiennent au module photovoltaïque à la première fréquence et qui sont commandés par le premier signal d'attaque comprend :

l'obtention de la tension de sortie et le courant de sortie qui appartiennent au module photovoltaïque à la première fréquence et qui sont commandés par le premier signal d'attaque, et d'une tension de sortie et d'un courant de sortie du module photovoltaïque à la seconde fréquence ; et
la détermination de l'impédance équivalente du module photovoltaïque sur la base de la tension de sortie et du courant de sortie du module photovoltaïque à la première fréquence comprend :
la détermination de l'impédance équivalente du module photovoltaïque sur la base de la tension de sortie et du courant de sortie du module photovoltaïque à la première fréquence et de la tension de sortie et du courant de sortie du module photovoltaïque à la seconde fréquence.

**6.** Procédé selon la revendication 5, dans lequel chacune des au moins deux fréquences différentes est inférieure à un seuil de fréquence, ou chacune des au moins deux fréquences différentes est supérieure ou égale à un seuil de fréquence.

**7.** Procédé selon l'une quelconque des revendications 1 à 4, dans lequel le procédé comprend :

la génération d'un second signal d'attaque sur la base de la première tension de référence et d'un signal de mesure de courant alternatif d'une seconde fréquence, et la commande de la tension de sortie du module photovoltaïque sur la base du second signal d'attaque ; et
l'obtention d'une tension de sortie et d'un courant de sortie qui appartiennent au module photovoltaïque à la seconde fréquence et qui sont commandés par le second signal d'attaque ; et
la détermination de l'impédance équivalente du module photovoltaïque sur la base de la tension de sortie et du courant de sortie du module photovoltaïque à la première fréquence comprend :
la détermination de l'impédance équivalente du module photovoltaïque sur la base de la tension de sortie et du courant de sortie du module photovoltaïque à la première fréquence et de la tension de sortie et du courant de sortie du module photovoltaïque à la seconde fréquence.

**8.** Procédé selon la revendication 5 ou 7, dans lequel la détermination de l'impédance équivalente du module photovoltaïque sur la base de la tension de sortie et du courant de sortie du module photovoltaïque à la première fréquence et de la tension de sortie et du courant de sortie du module photovoltaïque à la seconde fréquence comprend :

la détermination d'une composante d'impédance équivalente du module photovoltaïque à la première fréquence sur la base de la tension de sortie et du courant de sortie du module photovoltaïque à la première fréquence, et la détermination d'une composante d'impédance équivalente du module photovoltaïque à la seconde fréquence sur la base de la tension de sortie et du courant de sortie du module photovoltaïque à la seconde fréquence ; et
la détermination de l'impédance équivalente du module photovoltaïque sur la base de la composante d'impédance équivalente du module photovoltaïque à la première fréquence et de la composante d'impédance équivalente du module photovoltaïque à la seconde fréquence.

**9.** Procédé selon l'une quelconque des revendications 1 à 8, dans lequel le procédé comprend :
la détermination d'un état de fonctionnement actuel du dispositif de production d'énergie photovoltaïque, et la détermination de la première tension de référence sur la base de l'état de fonctionnement actuel du dispositif de production d'énergie photovoltaïque, dans lequel la première tension de référence est une tension d'entrée de référence du dispositif de production d'énergie photovoltaïque dans un état de fonctionnement à énergie limitée, ou une tension d'entrée de référence du dispositif de production d'énergie photovoltaïque dans un état de fonctionnement à énergie non limitée.

10. Dispositif de production d'énergie photovoltaïque (11),

dans lequel une extrémité d'entrée du dispositif de production d'énergie photovoltaïque est connectée à un module photovoltaïque (10), une extrémité de sortie du dispositif de production d'énergie photovoltaïque est connectée à un réseau électrique, et le dispositif de production d'énergie photovoltaïque comprend un dispositif de commande (112) et un circuit d'alimentation en énergie (111) ; une extrémité d'entrée du circuit d'alimentation en énergie est connectée à l'extrémité d'entrée du dispositif de production d'énergie photovoltaïque, une extrémité de sortie du circuit d'alimentation en énergie est connectée à l'extrémité de sortie du dispositif de production d'énergie photovoltaïque, et le circuit d'alimentation en énergie est configuré pour convertir une tension de sortie du module photovoltaïque en une tension de sortie du dispositif de production d'énergie photovoltaïque dans un état d'alimentation en énergie vers le réseau électrique ; et le dispositif de commande est configuré pour : générer un premier signal d'attaque sur la base d'une première tension de référence et d'un signal de mesure de courant alternatif d'une première fréquence, et commander une tension de sortie du module photovoltaïque sur la base du premier signal d'attaque, dans lequel la première tension de référence est une tension d'entrée de référence du dispositif de production d'énergie photovoltaïque dans l'état d'alimentation en énergie vers le réseau électrique ; obtenir une tension de sortie et d'un courant de sortie qui appartiennent au module photovoltaïque à la première fréquence et qui sont commandés par le premier signal d'attaque ; et déterminer une impédance équivalente du module photovoltaïque sur la base de la tension de sortie et du courant de sortie du module photovoltaïque à la première fréquence.

11. Dispositif de production d'énergie photovoltaïque selon la revendication 10, dans lequel le dispositif de commande est configuré pour : superposer la première tension de référence et le signal de mesure de courant alternatif pour obtenir une seconde tension de référence ; et générer une première onde de modulation sur la base de la seconde tension de référence et d'une tension de sortie de courant du module photovoltaïque, et générer le premier signal d'attaque sur la base de la première onde de modulation.

12. Dispositif de production d'énergie photovoltaïque selon la revendication 10, dans lequel le dispositif de commande est configuré pour : générer une deuxième onde de modulation sur la base de la première tension de référence et d'une tension de sortie de courant du module photovoltaïque ; et superposer la deuxième onde de modulation et le signal de mesure de courant alternatif pour obtenir une troisième onde de modulation, et générer le premier signal d'attaque sur la base de la troisième onde de modulation.

13. Dispositif de production d'énergie photovoltaïque selon l'une quelconque des revendications 10 à 12, dans lequel le dispositif de commande est configuré pour collecter une tension de sortie et un courant de sortie qui appartiennent au module photovoltaïque et qui sont commandés par le premier signal d'attaque, et réaliser un filtrage dans le domaine fréquentiel sur la tension de sortie et le courant de sortie du module photovoltaïque sur la base de la première fréquence, pour obtenir la tension de sortie et le courant de sortie du module photovoltaïque à la première fréquence.

14. Dispositif de production d'énergie photovoltaïque selon l'une quelconque des revendications 10 à 13, dans lequel le dispositif de commande est configuré pour générer le premier signal d'attaque sur la base de la première tension de référence et de signaux de mesure de courant alternatif d'au moins deux fréquences différentes, dans lequel les au moins deux fréquences différentes comprennent la première fréquence et une seconde fréquence ; et le dispositif de commande est configuré pour : obtenir la tension de sortie et le courant de sortie qui appartiennent au module photovoltaïque à la première fréquence et qui sont commandés par le premier signal d'attaque, et une tension de sortie et un courant de sortie du module photovoltaïque à la seconde fréquence ; et déterminer l'impédance équivalente du module photovoltaïque sur la base de la tension de sortie et du courant de sortie du module photovoltaïque à la première fréquence et de la tension de sortie et du courant de sortie du module photovoltaïque à la seconde fréquence.

15. Dispositif de production d'énergie photovoltaïque selon la revendication 14, dans lequel chacune des au moins deux fréquences différentes est inférieure à un seuil de fréquence, ou chacune des au moins deux fréquences différentes est supérieure ou égale à un seuil de fréquence.

FIG. 1

FIG. 2

Photovoltaic power
generation device 11

Controller 112

First drive
signal

Photovoltaic
module
voltage and
current

Power
supply
circuit
111

Photovoltaic
module 10

Power grid

Photovoltaic system 1

FIG. 3

Apparatus for measuring equivalent
impedance of a photovoltaic module

First
drive
signal

First determining
module 1123

Control module
1121

Photovoltaic
module
voltage and
current

$v(\omega_1), i(\omega_1)$

Obtaining module
1122

$\omega_1$

FIG. 4

Apparatus for measuring equivalent
impedance of a photovoltaic module

Control module 1121

Second
determining
module
1124

First superposition
unit 11211

Second superposition
unit 11214

First
drive
signal

$V_{ref1}$

Control
unit 11212

Modulation
wave

Modulation
unit 11213

Location
1

Location
2

Measurement signal
generation and
location selection
unit 11215

$A_1$

$\omega_1$

Photovoltaic
module
voltage

Obtaining
module 1122

Sampling
unit 11221

v

i

i

v

Filtering
unit 11222

$i\,(\omega_1)$

First determining
module
1123

Equivalent
impedance $Z\,(\omega_1)$

Photovoltaic
module
current

$v\,(\omega_1)$

FIG. 5

FIG. 6

FIG. 7

FIG. 8

FIG. 9

FIG. 10

FIG. 11

FIG. 12

FIG. 13

EP 4 344 056 B1

FIG. 14

FIG. 15

Generate a first drive signal based on a first reference voltage and an alternating current measurement signal of a first frequency, and control an output voltage of a photovoltaic module based on the first drive signal — S101

Obtain an output voltage and an output current that are of the photovoltaic module at the first frequency and that are controlled by the first drive signal — S102

Determine equivalent impedance that are of the photovoltaic module based on the output voltage and the output current of the photovoltaic module at the first frequency — S103

FIG. 16

**EP 4 344 056 B1**

## REFERENCES CITED IN THE DESCRIPTION

### Patent documents cited in the description

- US 2014111220 A